# EUROPEAN PATENT SPECIFICATION

(11) **EP 4 623 651 B1**
(45) Date of publication and mention of the grant of the patent: **04.11.2026**
(21) Application number: 23828859.1
(22) Date of filing: 15.11.2023
(51) Int. Cl.: H05K 7/14, H05K 7/20

(54) **MODULAR ACTUATOR CONTROL BASE MOUNT SYSTEM**
BASISHALTERUNGSSYSTEM FÜR MODULARE AKTUATORSTEUERUNG
SYSTÈME DE MONTAGE DE BASE DE COMMANDE D'ACTIONNEUR MODULAIRE

(30) Priority: 22.11.2022 US 202263427315 P
(43) Date of publication of application: 01.10.2025
(73) Proprietor: Moog Inc., East Aurora, NY 14052 (US)
(72) Inventor: OPIE, Ray, Orchard Park, New York 14127 (US)
(74) Representative: Hey, Andrew Stuart
(86) International application number: PCT/US2023/079832
(87) International publication number: WO 2024/112541

(56) References cited:
- WO-A1-2022/029177
- US-A1- 2008 218 966

## Description

### TECHNICAL FIELD

The present invention relates generally to actuator control systems, and more particularly to a modular actuator control base mount system.

### BACKGROUND ART

Electric motors that provide actuation in at least one motion axis are well known in the prior art and are used in a wide variety of industries. It is known that such motors can directly or indirectly drive linear or rotary actuators or may drive a pump to provide electrohydraulic linear or rotary actuation. It is also known that such actuation systems may include drive control and power electronics to control and supervise operation of the actuator.

International Patent Publication WO2022/187066, entitled "Modular Rugged Cooled Actuator Control System," discloses a modular actuator control system comprising a control module, a power module, and a plurality of actuator control modules stacked together to provide a compact, rugged, and cooled controller system for controlling a plurality of actuators. Patent application publication WO 2022/029177 A1 relates to a control cabinet system comprising a base module and at least one functional module wherein: the base module comprises a base housing having a first housing face and a second housing face; the functional module comprises a functional housing having a lower housing face (302); a circulation duct is located in the base housing; an air flow can be circulated in the circulation duct; each base connection element comprises circulation openings which are fluidically connected to the circulation duct; the functional connection element has coupling openings which are fluidically connected to an interior of the functional housing; the coupling openings can be coupled to the circulation openings; and, when the coupling openings are coupled to the circulation openings, a fluid connection is established between the circulation duct and the interior of the functional housing, and a fluidically closed circulation circuit is formed which comprises the circulation duct and the interior of the functional housing, in which circulation circuit an air flow can be circulated. Patent application publication US 2008/0218966 A1 relates to a mounting plate for electronic components, including cooling conduits that are integrated into a plate body and that are traversed by a coolant, a fixing device for mounting electronic components that are to be cooled being located on the plate body.

Mobile machines are generally land vehicles with attached machinery or equipment that are self-propelled or mobile and that, in contrast to automobiles, provide functionality beyond conveying people from one point to another. Mobile machines are known to include, without limitation, forklifts, skid steers, excavators, tractors, earthmovers, farm machinery, dump trucks, garbage trucks, mobile cranes, and other mobile construction equipment.

### BRIEF SUMMARY

With parenthetical reference to the corresponding parts, portions or surfaces of the disclosed embodiment, merely for purposes of illustration and not by way of limitation, a modular actuator control system (15, 215) is provided comprising: a module mounting base (25, 225); a first drive module (18, 19, 20, 21, 22) operatively configured to control an electrically powered first actuator (52, 53, 54, 55, 56, 57) having at least one motion axis; a second drive module (18, 19, 20, 21, 22) operatively configured to control an electrically power second actuator (52, 53, 54, 55, 56, 57) having at least one motion axis; the module mounting base having a base housing (26, 27, 227) comprising: a coolant inlet (181); a first base attachment (128, 158, 228, 258); a first base coolant port (188a, 188b, 189a, 189b, 190a, 190b, 191a, 191b, 192a, 192b); a second base attachment (128, 228 158, 258); a second base coolant port (188a, 188b, 189a, 189b, 190a, 190b, 191a, 191b, 192a, 192b); a power bus (170); and a signal bus (160); the first drive module having a first drive housing (30c, 30d) comprising: a first drive attachment (91c, 93c, 91d, 93d, 293) operatively configured to connect to the first base attachment; a first power connection (36c, 36d) operatively configured to connect to the power bus; a first signal connection (37c, 37d) operatively configured to connect to the signal bus; a first actuator drive connection (38c, 39c, 39d) operatively configured to connect to the first actuator; and a first coolant port (81c, 82c, 81d, 82d) operatively configured to connect to the first base coolant port; the second drive module having a second drive housing (30c, 30d) comprising: a second drive attachment (91c, 93c, 91d, 93d, 293) operatively configured to connect to the second base attachment; a second power connection (36c, 36d) operatively configured to connect to the power bus; a second signal connection (37c, 37d) operatively configured to connect to the signal bus; a second actuator drive connection (38c, 39c, 39d) operatively configured to connect to the second actuator; and a second coolant port (81c, 82c, 81d, 82d) operatively configured to connect to the second base coolant port; and the first drive module and the second drive module operatively configured to be removably attached to the module mounting base and to be in power communications with the power bus, in signal communications with the signal bus, and in coolant fluid communication with the coolant inlet.

The first base coolant port may comprise a first supply port (188a, 189a, 190a, 191a, 192a) and a first return port (188b, 189b, 190b, 191b, 192b); the second base coolant port may comprise a second supply port (188a, 189a, 190a, 191a, 192a) and a second return port (188b, 189b, 190b, 191b, 192b); the first coolant port may comprise a first inlet port (81c, 81d) and a first outlet port (82c, 82d); the second coolant port may comprise a second inlet port (81c, 81d) and a second outlet port (82c, 82d); the first drive housing may comprise a first coolant fluid flow path (87) between the first inlet port and the first outlet port; the second drive housing may comprise a second coolant fluid flow path (87) between the second inlet port and the second outlet port; the first supply port may be operatively configured to connect to the first inlet port and the first return port may be operatively configured to connect to the first outlet port; and the second supply port may be operatively configured to connect to the second inlet port and the second return port may be operatively configured to connect to the second outlet port. The base housing may comprise a first base coolant passage (183b, 183c, 183d, 183e) between the first return port and the second supply port.

The base housing may comprise a control base attachment (128a, 128b); the system may comprise a master controller module (16) having a controller housing (30a) comprising: a controller attachment (91a, 93a) operatively configured to connect to the control base attachment; a controller signal connection (37a) operatively configured to connect to the signal bus; and a system controller connection (64) operatively configured to communicate with a system controller (60); and the master controller module may be operatively configured to be removably attached to the module mounting base and to be in signal communication with the signal bus.

The base housing may comprise: a power base attachment (128b, 158b); and a power base coolant port (187a, 187b); the system may comprise a master power module (17) having a power housing (30b) comprising: a power attachment (91b, 93b) operatively configured to connect to the power base attachment; a master power connection (36b) operatively configured to connect to the power bus; a system power connection (66) operatively configured to connect to a system power source (70); and a power module coolant port (81b, 82b) operatively configured to connect to the power base coolant port; and the master power module may be operatively configured to be removably attached to the module mounting base and to be in power communications with the power bus and in coolant fluid communication with the coolant inlet.

The power housing may comprise a power signal connection (37b) operatively configured to connect to the signal bus. The first base coolant port may comprise a first supply port and a first return port; the second base coolant port may comprise a second supply port and a second return port; the power base coolant port may comprise a power supply port (187a) and a power return port (187b); the first coolant port may comprise a first inlet port and a first outlet port; the second coolant port may comprise a second inlet port and a second outlet port; the power module coolant port may comprise a power inlet port (81b) and a power outlet port (82b); the first drive housing may comprise a first coolant fluid flow path between the first inlet port and the first outlet port; the second drive housing may comprise a second coolant fluid flow path between the second inlet port and the second outlet port; the power housing may comprise a power coolant fluid flow path (87) between the power inlet port and the power outlet port; the first supply port may be operatively configured to connect to the first inlet port and the first return port may be operatively configured to connect to the first outlet port; the second supply port may be operatively configured to connect to the second inlet port and the second return port may be operatively configured to connect to the second outlet port; and the power supply port may be operatively configured to connect to the power inlet port and the power return port may be operatively configured to connect to the power outlet port. The modular actuator control system may comprise a pump (45) connected to the coolant inlet of the base housing and operatively configured to pump a fluid coolant through the first fluid coolant flow path of the first drive housing, the second fluid coolant flow path of the second housing, and the power coolant fluid flow path.

The base housing may comprise a control base attachment; the system may comprise a master controller module having a controller housing comprising: a controller attachment operatively configured to connect to the control base attachment; a controller signal connection operatively configured to connect to the signal bus; and a controller system connection operatively configured to communicate with a system controller; and the master controller module may be operatively configured to be removably attached to the module mounting base and to be in signal communication with the signal bus. The master power module may be supported by the module mounting base between the master controller module and the first drive module. The system power source may comprise an electric-vehicle battery (70).

The first base attachment may comprise a first base bolt hole (128, 158, 228, 258); the first drive attachment may comprise a first module bolt hole (91c, 93c, 91d, 93d, 293); and the first drive attachment may be operatively configured to connect to the first base attachment via a first bolt (129, 159, 229, 259) extending between and through the first base bolt hole and the first module bolt hole.

The base housing may comprise a base plate (26) and a back plate (27) and the power bus and the signal bus may be contained in the back plate. The first base attachment may comprise a base plate attachment (128) and a back plate attachment (158). The coolant inlet may comprise an inlet port in the back plate and the back plate may comprise an outlet port (182). The base plate may comprise a first base keyway (118, 119, 120, 121, 122) configured to mate with a corresponding key of the first drive module and a second base keyway (118, 119, 120, 121, 122) configured to mate with a corresponding key of the second drive module.

The base housing may comprise a back plate (227) and the power bus and the signal bus may be contained in the back plate. The first base attachment may comprise a first back plate attachment (228) and a second back plate attachment (258). The back plate may comprise a first key (216) configured to mate with a corresponding key of the first drive module and a second key configured to mate with a corresponding key of the second drive module.

### BRIEF DESCRIPTION OF THE DRAWINGS

The accompanying drawings are incorporated herein as part of the specification. The drawings described herein illustrate embodiments of the presently disclosed subject matter and are illustrative of selected principles and teachings of the present disclosure. However, the drawings do not illustrate all possible implementations of the presently disclosed subject matter and are not intended to limit the scope of the present disclosure in any way.
FIG. 1 is a front isometric view of an embodiment of an improved modular actuator control system.
FIG. 2 is a front isometric view of the modular actuator control support structure shown in FIG. 1.
FIG. 3 is a partial rear isometric exploded view of the modular actuator control support structure back plate shown in FIG. 2.
FIG. 4 is a front plan view of the modular actuator control support structure back plate shown in FIG. 2.
FIG. 5 is a rear plan view of the modular actuator control support structure back plate shown in FIG. 4.
FIG. 6 is a front isometric view of the modular actuator control support structure base plate shown in FIG. 2.
FIG. 7 is a front isometric view of an embodiment of the control bus and power bus show in FIG. 2.
FIG. 8 is a front schematic view of the backplane control, power and coolant buses shown in FIG. 2.
FIG. 9 is a front isometric view of the master controller module shown in FIG. 1.
FIG. 10 is a rear plan view of the master controller module shown in FIG. 9.
FIG. 11 is a front isometric view of the master power module shown in FIG. 1.
FIG. 12 is a rear plan view of the master power module shown in FIG. 11.
FIG. 13 is a front isometric view of one of the dual axis actuator drive modules shown in FIG. 1.
FIG. 14 is a rear plan view of the dual axis actuator drive module shown in FIG. 13.
FIG. 15 is a front isometric view of one of the single axis actuator drive modules shown in FIG. 1.
FIG. 16 is a rear plan view of the single axis actuator drive module shown in FIG. 15.
FIGS. 17A-17F are isometric views illustrating the mounting of the modules in the modular actuator control support structure shown in FIG. 1 mounted in an embodiment of a mobile machine.
FIGS. 18A and 18B are isometric views illustrating the removal of a module from the modular actuator control support structure shown in FIG. 17F.
FIG. 19 is a vertical longitudinal sectional schematic view of an embodiment cooling conduit profile of a module shown in FIG. 1.
FIG. 20 is a schematic view of a four drive module embodiment of the modular actuator control system shown in FIG. 1 operationally coupled to an example vehicle with a liquid cooling system and multiple example actuators.
FIG. 21 is a front isometric view of an alternative embodiment of the modular actuator control support structure shown in FIG. 2.
FIG. 22 is a front isometric view of an embodiment of an improved modular actuator control system with the modular actuator control support structure shown in FIG. 21.

### DETAILED DESCRIPTION OF THE EMBODIMENTS

At the outset, it should be clearly understood that like reference numerals are intended to identify the same structural elements, portions or surfaces consistently throughout the several drawing figures, as such elements, portions or surfaces may be further described or explained by the entire written specification, of which this detailed description is an integral part. Unless otherwise indicated, the drawings are intended to be read (e.g., crosshatching, arrangement of parts, proportion, degree, etc.) together with the specification, and are to be considered a portion of the entire written description of this invention. As used in the following description, the terms "horizontal", "vertical", "left", "right", "up" and "down", as well as adjectival and adverbial derivatives thereof (e.g., "horizontally", "rightwardly", "upwardly", etc.), simply refer to the orientation of the illustrated structure as the particular drawing figure faces the reader. Similarly, the terms "inwardly" and "outwardly" generally refer to the orientation of a surface relative to its axis of elongation, or axis of rotation, as appropriate.

It is to be understood that the specific assemblies and systems illustrated in the attached drawings and described in the following specification are simply exemplary embodiments. Hence, specific dimensions, directions, or other physical characteristics relating to the embodiments disclosed are not to be considered as limiting, unless expressly stated otherwise. Also, although they may not be, like elements in various embodiments described herein may be commonly referred to with like reference numerals within this section of the application.

It is to be appreciated that the present teaching is by way of example only, not by limitation. The concepts herein are not limited to use or application with a specific system or method. Thus, although the instrumentalities described herein are for the convenience of explanation, shown and described with respect to exemplary embodiments, it will be appreciated that the principles herein may be applied equally in other types of systems and methods.

Where they are used herein, the terms "first," "second," and so forth, do not necessarily denote any ordinal, sequential or priority relation, but are simply used to distinguish one element or set of elements more clearly from another element or set of elements, unless specified otherwise.

Referring now to the drawings, a modular actuator control module base mount system is provided, a first embodiment of which is generally indicated at 15. As shown, system 15 generally comprises base 25 configured to support and link one or more actuator control modules 16-22 such that the actuator control modules key and plug into base 25 for connection to associated power, command, and cooling. As described further below, individual modules 16-22 may be removably mounted and plugged into base 25, with base 25 configured to be mounted on a mobile machine, such as skid steer 29, such that drive modules 18-22 may be connected to and control one or more actuators 52-57 on the mobile machine. In this embodiment, module 16 is a master controller module, module 17 is a master power module, modules 18-20 are each dual axis actuator drive modules, and modules 21 and 22 are each single axis actuator drive modules. In this embodiment, base 25 generally comprises horizontally extending base plate 26 and attached vertically extending back plate 27.

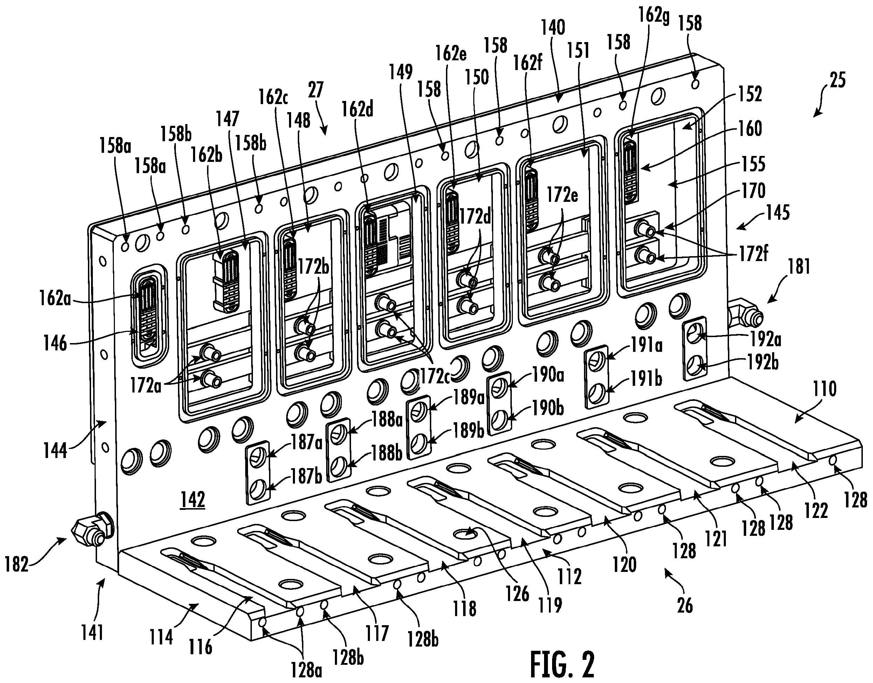

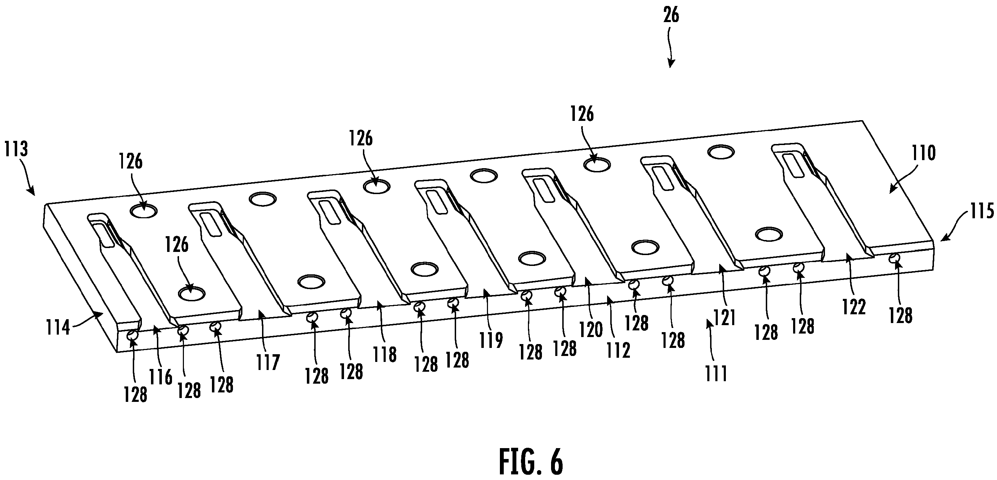

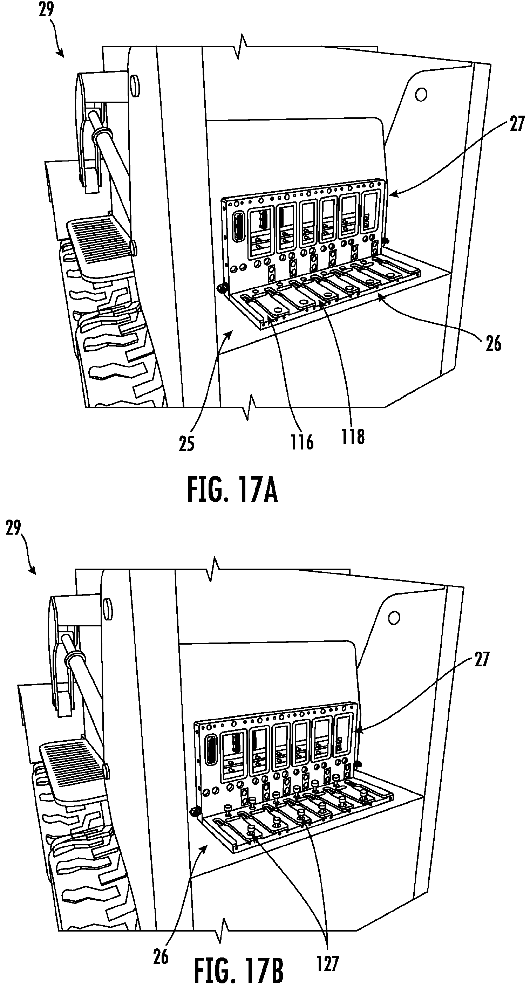

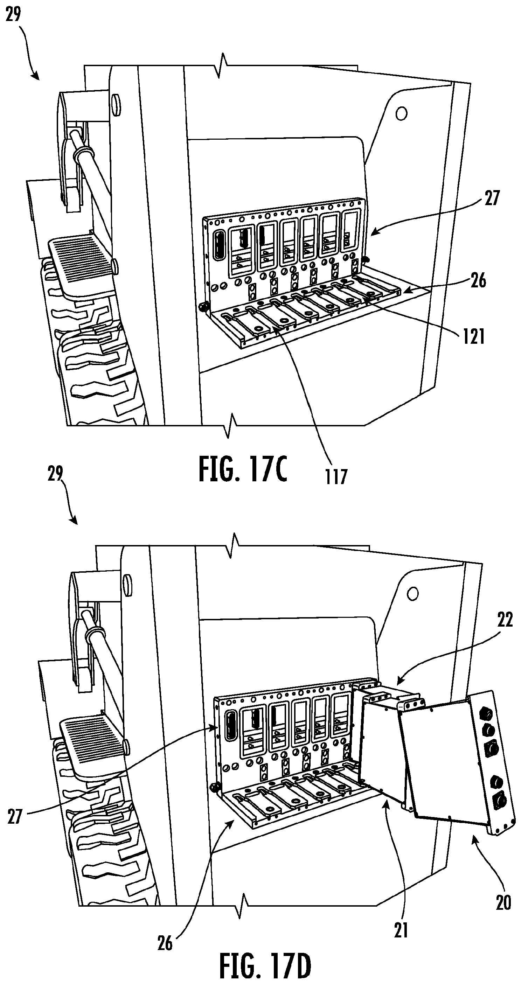

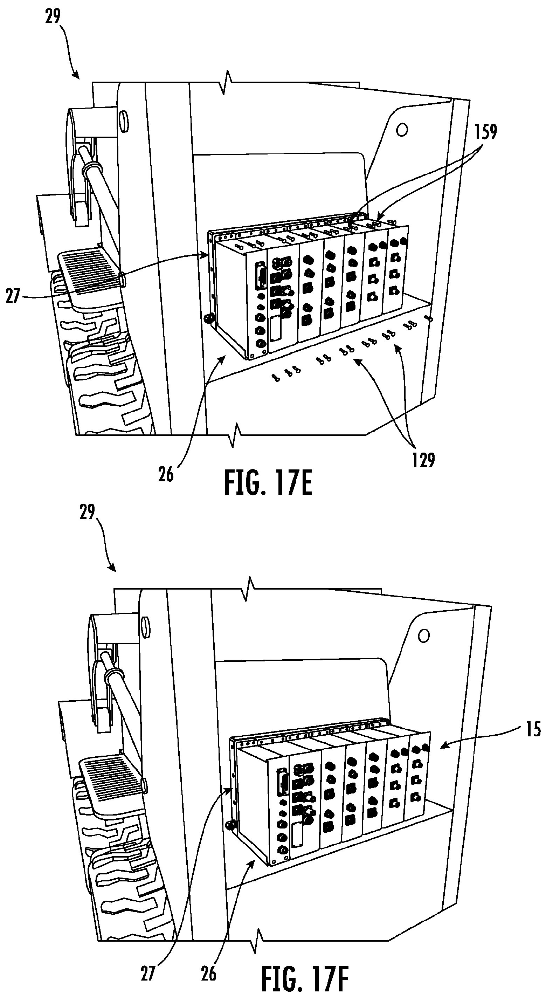

As shown in FIGS. 2 and 6, base plate 26 is generally bounded by top horizontal surface 110, bottom horizontal surface 111, front vertical surface 112, rear vertical surface 113, left vertical side surface 114, and right vertical side surface 115. A plurality of vehicle mounting holes, severally indicated at 126, extend through base plate 26 from top surface 110 to bottom surface 111 and are configured to receive corresponding mounting bolts or screws 127 such that base plate 26 may be mounted to a vehicle, such as skid steer 29, as shown in FIGS. 17A-17C.

Top and front surfaces 110 and 112 include specially configured recessed keyways 116-122 that correspond to matching keys in the base of modules 16-22, respectively, so that modules 16-22 may be located properly on base 25 during installation, as shown in FIG. 17D. Thus, in this embodiment keyway system 123 is provided in base plate 26 such that keyway 116 matches to module 16, keyway 117 matches to module 17, keyway 118 matches to module 18, keyway 119 matches to module 19, keyway 120 matches to module 20, keyway 121 matches to module 21, and keyway 22 matches to module 22. Different types of modules may have different keys and corresponding keyways in base plate 26 if desired to assure that each type of module is properly aligned along backplane 28 of base 25. Thus, modules 16-22 are keyed to a location along backplane 28 of base 25 so as to prevent the wrong type of module from being installed in a specific location along back plate 27 of base 25. Thus, for example, keyway 116 may be configured to only accept a master control module 16, keyway 117 may be configured to only accept a master power module 17, keyways 118-120 may each be configured to only accept a dual axis actuator drive module 18, 19 or 20, and/or keyways 121 and 122 may each be configured to only accept a single axis actuator drive module 21 or 22.

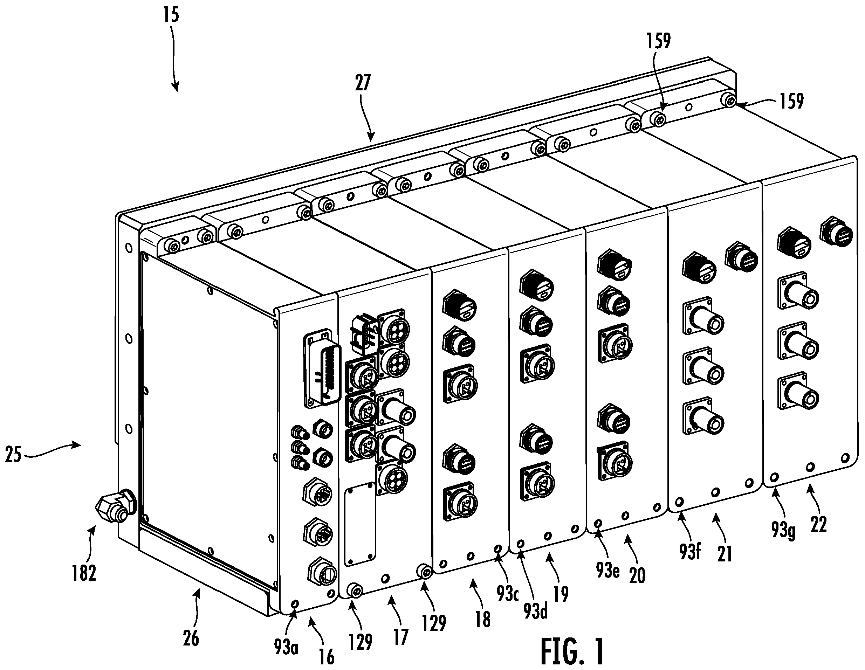

Front surface 112 includes pairs of horizontally spaced threaded module mounting bolt holes, severally indicated at 128, that are configured to receive corresponding module mounting bolts, severally indicated at 129, such that each of modules 16-22 may be removably mounted to base plate 26 as shown in FIGS. 17E-17F. Rear surface 113 includes a plurality of threaded back plate mounting bolt holes (not shown) that are configured to receive corresponding mounting bolts (not shown) such that back plate 27 may be removably mounted to base plate 26 as shown in FIGS. 1 and 2. Base plate 26 may be a solid unitary member.

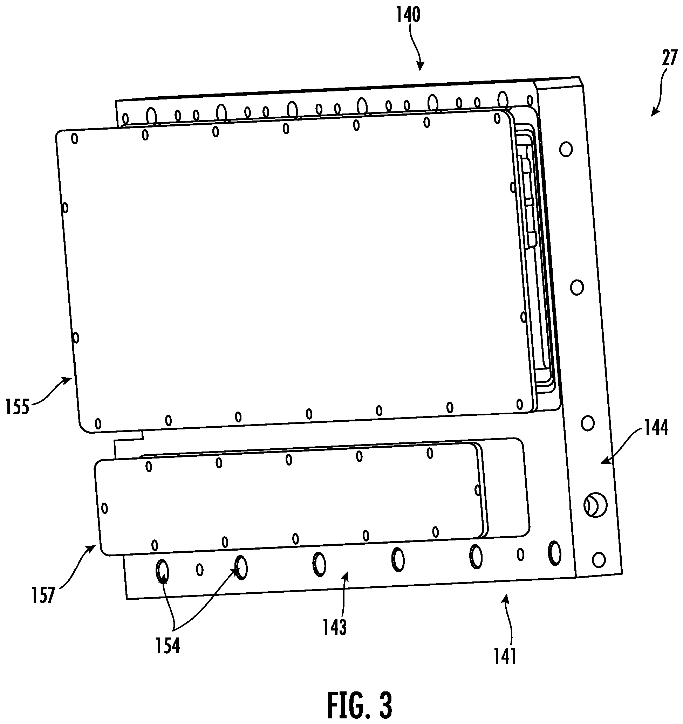

As shown in FIGS. 2-5, back plate 27 is configured to house control bus 160, power bus 170, and cooling bus 180 of backplane 28 of base 25. Back plate 27 is a sturdy enclosure generally comprising top horizontal surface 140, bottom horizontal surface 141, front vertical surface panel 142, rear vertical surface panel 143, right vertical surface 145, and left vertical surface 144. The top edge of back plate 27 includes pairs of horizontally-spaced module mounting bolt holes, severally indicated at 158, that are configured to receive corresponding module mounting bolts, severally indicated at 159, such that each of modules 16-22 may be removably mounted to back plate 27 as shown in FIGS. 17E-17F. The bottom edge of back plate 27 includes a plurality of base plate mounting bolt holes 153 that are configured to receive corresponding mounting bolts (not shown) such that back plate 27 may be removably mounted to base plate 26 as shown in FIGS. 1 and 2.

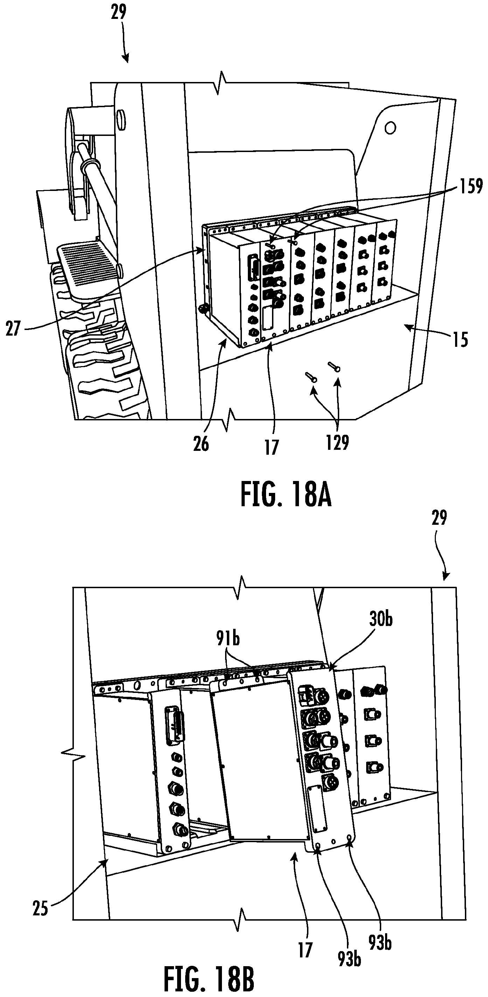

One or more of modules 16-22 may be easily removed for replacement from base 25 by removing the applicable bolts 159 from the applicable mounting holes 158 of back plate 27 and the applicable bolts 129 from the applicable mounting holes 128 of base plate 26 and unplugging the coolant, signal, and power connections from base 25. As shown in FIGS. 18A and 18B by way of example, master power module 17 way be removed from base 25 by removing bolts 129 from module bolts holes 93b and corresponding base plate bolt holes 128b to detach housing 30b from base plate 26, by removing bolts 159 from module bolts holes 91b and corresponding back plate bolt holes 158b to detach housing 30b from back plate 27, by disconnecting power connection 136b from power connection 172a of bus 170, by disconnecting signal connection 37b from connection 162b of signal bus 160, and by disconnecting ports 81b and 82b from ports 187a and 187b of back plate 27, respectively, such that module 17 is fully detached and disconnected from base 25 and may be removed and replaced as needed.

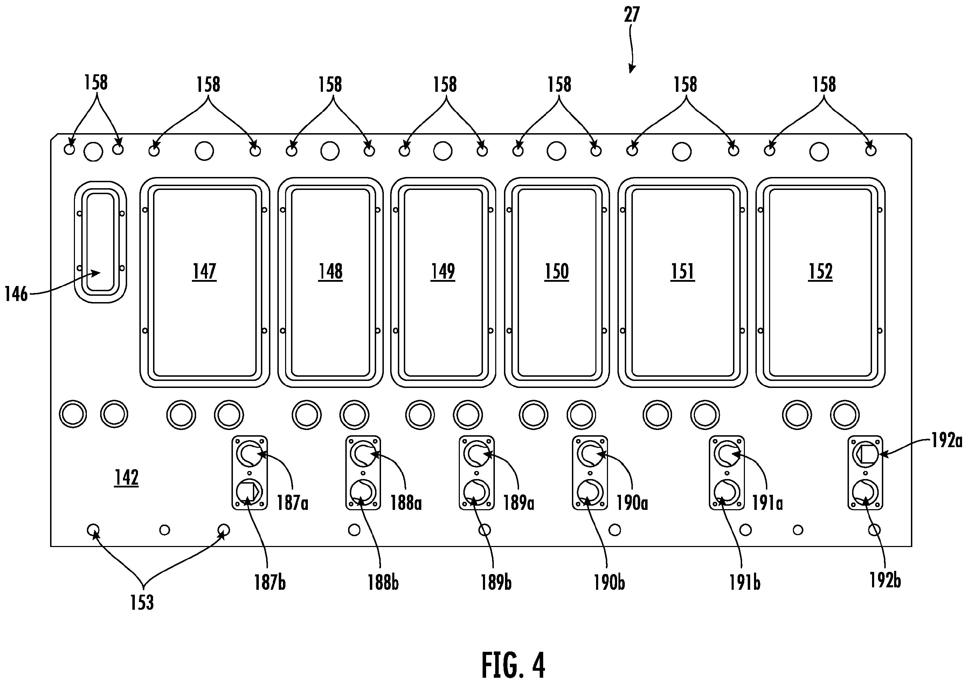

As shown in FIG. 4, front panel 142 includes electronic connection openings 146-152. Opening 146 is aligned with keyway 116 to provide a passage through back plate 27 for connecting connection 162a of control signal bus 160 to connection 37a and master control electronics 61 of master control module 16, with the rear panel of control module 16 having a correspondingly positioned and sized connection opening 50a when module 16 is properly located in keyway 116. Opening 147 is aligned with keyway 117 to provide a passage through back plate 27 for connecting connection 162b of control bus 160 to connection 37b and control power electronics 62 of master power module 17 and for connecting connection 172a of power bus 170 to connection 36b and master power electronics 63 of master power module 17, with the rear panel of power module 17 having a correspondingly positioned and sized opening 50b when module 17 is properly located in keyway 117. Opening 148 is aligned with keyway 118 to provide a passage through back plate 27 for connecting connection 162c of control bus 160 to connection 37c and control electronics 32c of dual axis actuator drive module 18 and connection 172b of power bus 170 to connection 36c and power electronics 31c of dual axis actuator drive module 18, with the rear panel of dual axis actuator drive module 18 having a correspondingly positioned and sized opening 50c when module 18 is properly located in keyway 118. Opening 149 is aligned with keyway 119 to provide a passage through back plate 27 for connecting connection 162d of control bus 160 to connection 37c and control electronics 32c of dual axis actuator drive module 19 and connection 172c of power bus 170 to connection 36c and power electronics 31c of dual axis actuator drive module 19, with the rear panel of dual axis actuator drive module 19 having a correspondingly positioned and sized opening 50c when module 19 is properly located in keyway 119. Opening 150 is aligned with keyway 120 to provide a passage through back plate 27 for connecting connection 162e of control bus 160 to connection 37c and control electronics 32c of dual axis actuator drive module 20 and connection 172d of power bus 170 to connection 36c and power electronics 31c of dual axis actuator drive module 20, with the rear panel of dual axis actuator drive module 20 having a correspondingly positioned and sized opening 50c when module 20 is properly located in keyway 120. Opening 151 is aligned with keyway 121 to provide a passage through back plate 27 for connecting connection 162f of control bus 160 to connection 37d and control electronics 32d of single axis actuator drive module 21 and connection 172e of power bus 170 to connection 36d and power electronics 31d of single axis actuator drive module 21, with the rear panel of single axis actuator drive module 21 having a correspondingly positioned and sized opening 50d when module 21 is properly located in keyway 121. Opening 152 is aligned with keyway 122 to provide a passage through back plate 27 for connecting connection 162g of control bus 160 to connection 37d and control electronics 32d of single axis actuator drive module 22 and connection 172f of power bus 170 to connection 36d and power electronics 31d of single axis actuator drive module 22, with the rear panel of single axis actuator drive module 22 having a correspondingly positioned and sized opening 50d when module 22 is properly located in keyway 122.

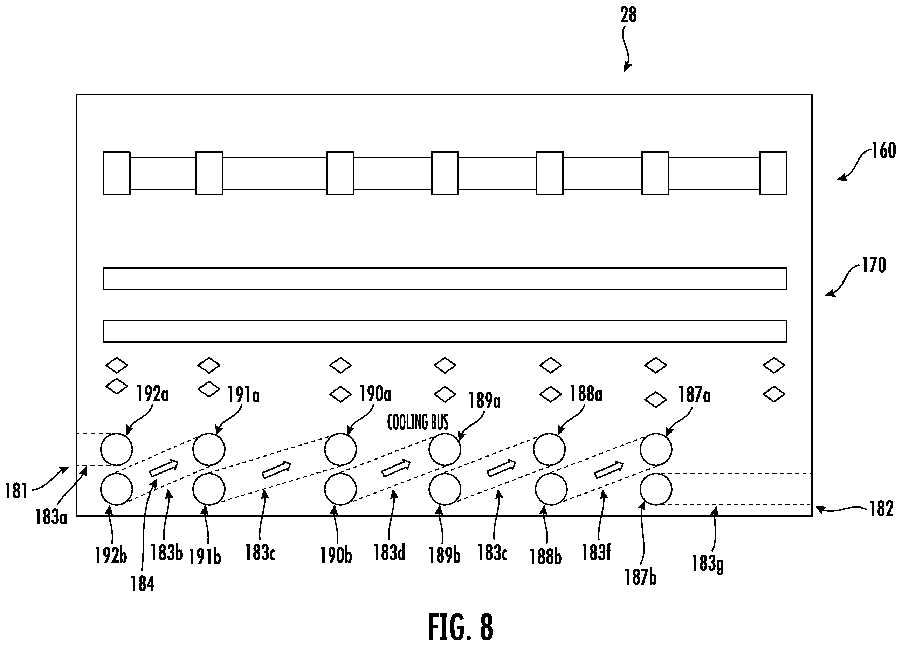

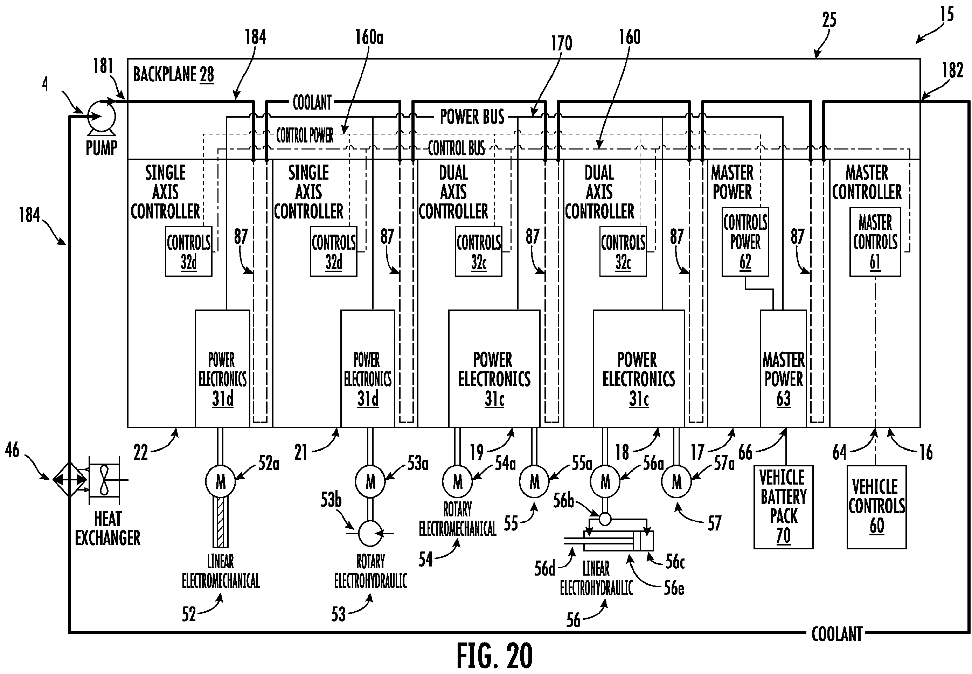

As shown in FIG. 2, right side 145 of back plate 27 includes coolant system inlet port 181 and left side 144 of back plate 27 includes coolant system outlet port 182. As shown in FIG. 20, coolant inlet port 181 and outlet port 182 are connected to a coolant system on vehicle 29 that includes coolant circulating pump 45 and heat exchanger 46. As shown in FIGS. 2, 4 and 8, front panel 142 includes module coolant supply ports 187a, 188a, 189a, 190a, 191a and 192a. Front panel 142 also includes module coolant return ports 187b, 188b, 189b, 190b, 191b and 192b. Passage 183a in lower back plate 27 extends between inlet 181 and supply port 192a, passage 183b in lower back plate 27 extends between return port 192b and supply port 191a, passage 183c in lower back plate 27 extends between return port 191b and supply port 190a, passage 183d in lower back plate 27 extends between return port 190b and supply port 189a, passage 183e in lower back plate 27 extends between return port 189b and supply port 188a, passage 183f in lower back plate 27 extends between return port 188b and supply port 187a, and passage 183g in lower back plate 27 extends between return port 187b and outlet port 182.

Supply port 187a is aligned with keyway 117 to provide a coolant fluid passage from back plate 27 to fluid coolant inlet 81b of master power module 17, with the rear panel of power module 17 having correspondingly positioned and sized coolant inlet 81b that mates with port 187a when module 17 is properly located in keyway 117. Return port 187b is similarly aligned with keyway 117 to provide a coolant fluid passage from fluid coolant outlet 82b of master power module 17 to back plate 27, with the rear panel of power module 17 having correspondingly positioned and sized coolant outlet 82b that mates with return port 187b when module 17 is properly located in keyway 117. Supply port 188a is aligned with keyway 118 to provide a coolant fluid passage from back plate 27 to fluid coolant inlet 81c of dual axis actuator drive module 18, with the rear panel of dual axis actuator drive module 18 having correspondingly positioned and sized coolant inlet 81c that mates with port 188a when module 18 is properly located in keyway 118. Return port 188b is similarly aligned with keyway 118 to provide a coolant fluid passage from fluid coolant outlet 82c of dual axis actuator drive module 18 to back plate 27, with the rear panel of dual axis actuator drive module 18 having correspondingly positioned and sized coolant outlet 82c that mates with return port 188b when module 18 is properly located in keyway 118. Supply port 189a is aligned with keyway 119 to provide a coolant fluid passage from back plate 27 to fluid coolant inlet 81c of dual axis actuator drive module 19, with the rear panel of dual axis actuator drive module 19 having correspondingly positioned and sized coolant inlet 81c that mates with port 189a when module 19 is properly located in keyway 119. Return port 189b is similarly aligned with keyway 119 to provide a coolant fluid passage from fluid coolant outlet 82c of dual axis actuator drive module 19 to back plate 27, with the rear panel of dual axis actuator drive module 19 having correspondingly positioned and sized coolant outlet 82c that mates with return port 189b when module 19 is properly located in keyway 119. Supply port 190a is aligned with keyway 120 to provide a coolant fluid passage from back plate 27 to fluid coolant inlet 81c of dual axis actuator drive module 20, with the rear panel of dual axis actuator drive module 20 having correspondingly positioned and sized coolant inlet 81c that mates with port 190a when module 20 is properly located in keyway 120. Return port 190b is similarly aligned with keyway 120 to provide a coolant fluid passage from fluid coolant outlet 82c of dual axis actuator drive module 20 to back plate 27, with the rear panel of dual axis actuator drive module 20 having correspondingly positioned and sized coolant outlet 82c that mates with return port 190b when module 20 is properly located in keyway 120. Supply port 191a is aligned with keyway 121 to provide a coolant fluid passage from back plate 27 to fluid coolant inlet 81d of single axis actuator drive module 21, with the rear panel of single axis actuator drive module 21 having correspondingly positioned and sized coolant inlet 81d that mates with port 191a when module 21 is properly located in keyway 121. Return port 191b is similarly aligned with keyway 121 to provide a coolant fluid passage from fluid coolant outlet 82d of single axis actuator drive module 21 to back plate 27, with the rear panel of single axis actuator drive module 21 having correspondingly positioned and sized coolant outlet 82d that mates with return port 191b when module 21 is properly located in keyway 121. Supply port 192a is aligned with keyway 122 to provide a coolant fluid passage from back plate 27 to fluid coolant inlet 81d of single axis actuator drive module 22, with the rear panel of single axis actuator drive module 22 having correspondingly positioned and sized coolant inlet 81d that mates with port 192a when module 22 is properly located in keyway 122. Return port 192b is similarly aligned with keyway 122 to provide a coolant fluid passage from fluid coolant outlet 82d of single axis actuator drive module 22 to back plate 27, with the rear panel of single axis actuator drive module 22 having correspondingly positioned and sized coolant outlet 82d that mates with return port 192b when module 22 is properly located in keyway 122

Thus, when base 25 is connected to modules 16-22 and with pump 45 circulating coolant fluid, coolant flow path 184 extends in through inlet 181 and in series through passage 183a, out supply port 192a, through module 22, in return port 192b, through passage 183b, out supply port 191a, through module 21, in return port 191b, through passage 183c, out supply port 190a, through module 20, in return port 190b, through passage 183d, out supply port 189a, through module 19, in return port 189b, through passage 183e, out supply port 188a, through module 18, in return port 188b, through passage 183f, out supply port 187a, through module 17, in return port 187b, through passage 183g, and out through outlet 182.

While in this embodiment, ports are not provided to master control module 16 and master control module is not cooled via pump 45, heat exchanger 46 and coolant fluid path 184, alternatively ports and passages may be added in series in back plate 27 such that flow path 184 extends through and cools module 16 before exiting back plate 27 via outlet port 182.

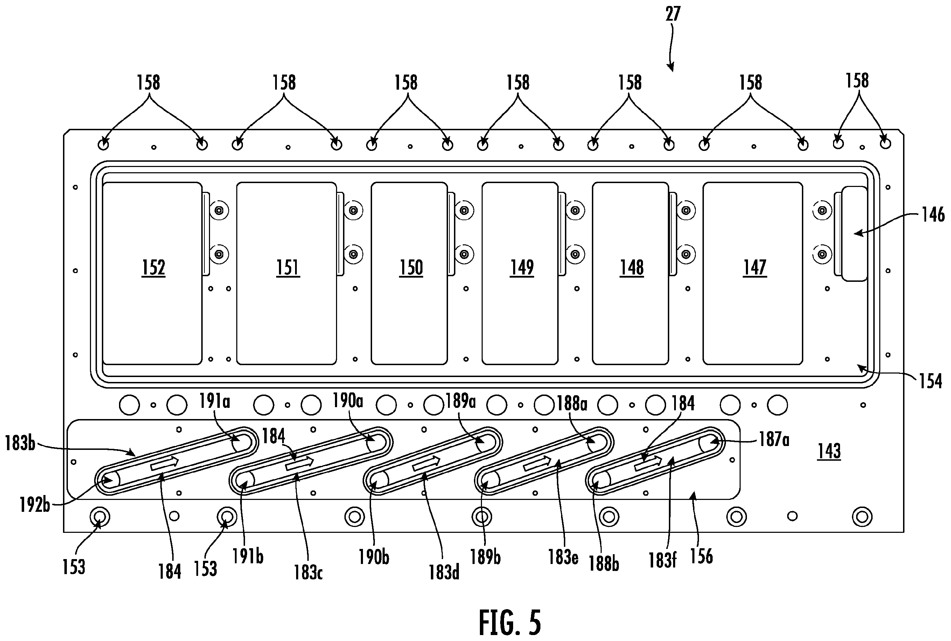

As shown in FIG. 5, rear panel 143 includes module power and command access opening 154 that is covered and sealed by removable cover 155 and separate cooling access opening 156 that is covered and sealed by removable cover 157.

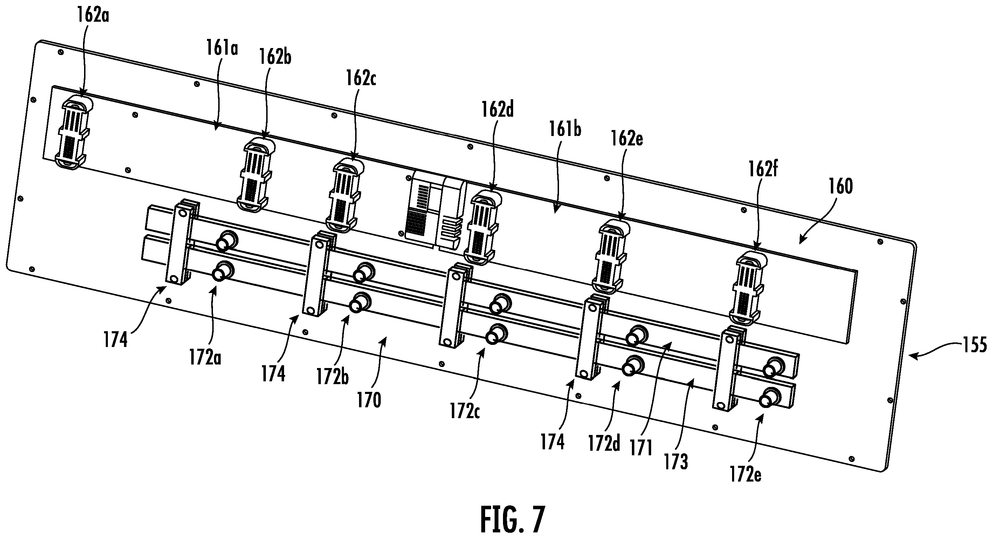

As shown in FIG. 7, in this embodiment control bus 60 generally comprises two connected printed circuit boards 161a and 161b supporting mounted control bus connectors 162a, 162b, 162c, 162d, 162e, 162f and 162g. Control bus connectors 162a, 162b, 162c, 162d, 162e, 162f and 162g are spaced apart on boards 161a and 162b so that they align with keyways 116, 117, 118, 119, 120, 121 and 122, respectively, and to provide a signal and low voltage control power connection through openings 146, 147, 148, 149, 150, 151 and 152 to connectors 37a, 37b, 37c and 37d and control electronics 61, 62, 32c and 32d of modules 16, 17, 18, 19, 20, 21 and 22, respectively. Control bus 160 may have, for example and without limitation, 4 high current circuits, 24 signal circuits, and 8 spare signal circuits. In this embodiment control bus connectors 162a, 162b, 162c, 162d, 162e, 162f and 162g and module connectors 37a, 37b, 37c and 37d are multipin mating connectors that provide communication signals and also low voltage power 160a. However, alternative bus circuits and configurations may be employed depending on the application.

In this embodiment, power bus 170 is a DC bus generally comprising two copper bus bars 171 and 173, one for power positive and one for power negative, supported by a plurality of spaced apart insulators, severally indicated at 174, and having DC connectors 172a, 172b, 172c, 172d, 172e, and 172f press fit into them, respectively. DC connectors 172a, 172b, 172c, 172d, 172e, and 172f are spaced apart on each of bus bars 171 and 173 so that they align with keyways 117, 118, 119, 120, 121 and 122, respectively, and to provide an electrical connection through openings 147, 148, 149, 150, 151 and 152 to connectors 36b, 36c and 36d and power electronics 63, 31c and 31d of modules 17, 18, 19, 20, 21 and 22, respectively. In this embodiment power bus connectors 172a, 172b, 172c, 172d, 172e, and 172f and module connectors 36b, 36c and 36d are single pin mating connectors.

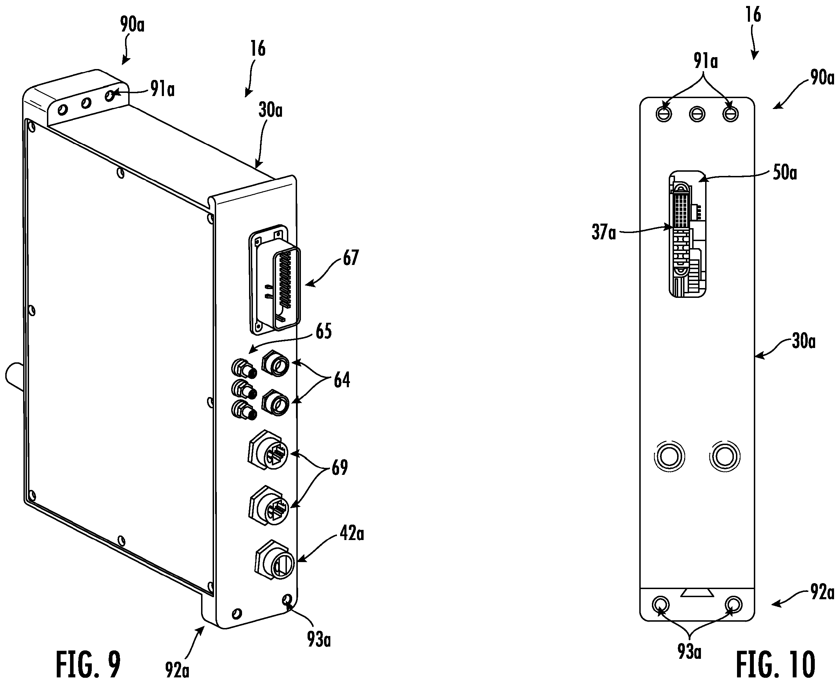

Referring now to FIGS. 9-16, various different types of modules may be supported by base 25. In this embodiment, example modules include master control module 16, master power module 17, dual axis actuator drive modules 18-20, and single axis actuator drive modules 21 and 22, which are all configured to be stacked together on base 25 to provide compact, rugged, and cooled controller system 15 for controlling a plurality of actuators. Each of modules 16-22 seals against base 25, via gaskets, O-rings or face seals for example, to prevent the ingress of dust and water from the surrounding environment. For example, and without limitation, actuator drive modules 18, 19 and 20, which are dual drive modules, may each control both a linear electrohydraulic actuator 56 and a rotary electromechanical actuator 57 or two rotary electromechanical actuators 54 and 55 on mobile machine 29. Actuator drive module 21 may control a linear electromechanical actuator 52 on mobile machine 29 and actuator drive module 22 may control a rotary electrohydraulic actuator 53 on mobile machine 29.

While the embodiment 15 shown in FIG. 1 includes five actuator drive modules 18-22 that can control eight actuators, other configurations may be employed depending on the desired application. For example, and without limitation, as shown in FIG. 20 less than five actuator drive modules may be supported together on base 25 as desired, or more than five actuator drive modules may be supported together on base 25 as desired. In addition, and without limitation, the actuator control modules may be configured to control alternative types of actuators. Thus, the modular system is easily adaptable and expandable and may comprise different stacked actuator control modules depending on the desired actuator count and functionality.

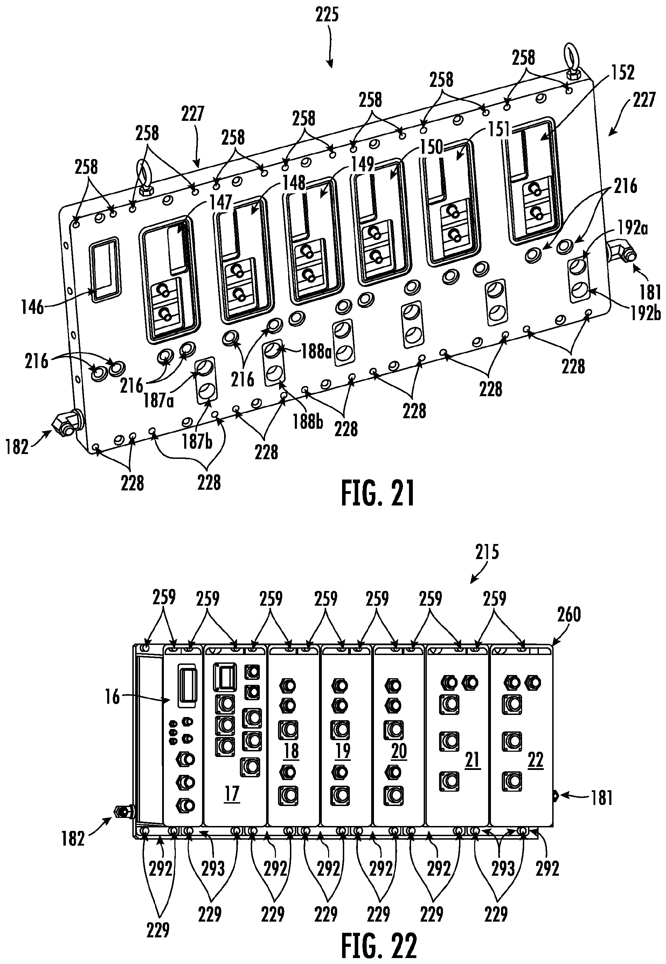

While in the embodiment 15 shown in FIG. 2 base 25 is formed from horizontal base plate 26 together with vertical back plate 27, alternatively backplane 28 may be formed from only a vertical back plate 227 with no horizontal base plate, as shown in FIGS. 21 and 22. In such alternative embodiment 215, the top edge of back plate 227 of base 225 includes pairs of horizontally-spaced module mounting bolt holes, severally indicated at 258, that are configured to receive corresponding module mounting bolts, severally indicated at 259, such that the top rear flange portion 90 of each of modules 16-22 may be removably mounted to back plate 227 as shown in FIG. 21. However, in this embodiment, the bottom rear edge portion of each of modules 16-22 is also provided with a mounting flange, severally indicated at 292, having bolt holes, severally indicated at 293, and the bottom edge of back plate 227 includes horizontally-spaced module mounting bolt holes, severally indicated at 228, that are also configured to receive corresponding module mounting bolts, severally indicated at 229, such that the bottom rear portion of each of modules 16-22 may be removably mounted directly to back plate 227 as shown in FIGS. 21.

In such alternative embodiment 215, the vertical back plate 227 may also include specially configured keys, severally indicated at 216, that correspond to matching key holes in the rear panel of modules 16-22, respectively, so that modules 16-22 will be located properly along vertical back plate 227 forming backplane 28. So different types of modules would have different keys in back plate 227 if desired to assure that each type of module is properly aligned along the module mounting base 225. Thus, modules 16-22 may be keyed to a location along the vertical back plate 227 of backplane 28 of module mounting base 225, rather than to a horizontal base plate, so as to prevent the wrong type of module from being installed in a specific location along the back plate of the module mounting base. Also in such alternative embodiment 215, the top front edge portion of each of modules 16-22 may be provided with a handle 260 configured so that modules 16-22 may be more easily lifted and maneuvered in and out of place by a user.

In an exemplary embodiment, master controller module 16 generally comprises housing 30a containing master control electronics 61 and rear communication control bus connection 37a. Housing 30a protects the internal electronics of the module from the outside environment and provides front end actuator connections, backend base connections, and mounting connections when mounted on base 25 as shown and described.

As shown in FIG. 9, the front panel of housing 30a includes external hardwired communication bus connection 64, external wireless antenna interface 65, general purpose auxiliary analog and digital interface 67, ethernet ports 69, and USB port 42a. The bottom front edge portion of housing 30a also includes mounting flange 92a having at least two horizontally spaced base plate mounting bolt holes, severally indicated at 93a, that are configured to receive corresponding module mounting bolts 129, such that module 16 may be removably mounted to base plate 26 as shown in FIGS 17E-17F.

As shown in FIG. 10, the rear panel of housing 30a includes opening 50a through which communication connection 37a is operatively connected to communications and control bus 160 of base 25. The top rear edge portion of housing 30a also includes mounting flange 90a having at least two horizontally-spaced base mounting bolt holes, severally indicated at 91a, that are configured to receive corresponding module mounting bolts 159, such that module 16 may be removably mounted to back plate 27 as shown in FIGS 17E-17F.

Master control electronics 61 in housing 30a receive commands from vehicle controls 60 via connection 64, control, monitor and supervise operation of individual actuator control modules 17-22, and include an internal communication board interface, a master processor, regenerative braking electronics, a DC capacitor, an external wired communication board interface and an external wireless board interface. The communication interface provides communications with each of actuator drive modules 18-22 via communication connection 37a and bus 160 of base 25 and communicates data, commands, and states. The processor provides control and monitoring of modules 17-22. The processor receives commands and input from vehicle controls 60, via connection 64 for example, and feedback from modules 17-22, via communication bus 160 of base 25, and provides command signals and controls modules 17-22, via communication bus 160 of base 25, accordingly. The processor is configured to perform a variety of computer-implemented functions such as performing method steps, calculations and the like and storing relevant data and may be a digital device which has output lines that are a logic function of its input lines, examples of which include a microprocessor, microcontroller, FPGA, PLD, application specific integrated circuit, or other similar devices.

In this embodiment, master power module 17 generally comprises housing 30b containing control power electronics 63, low voltage power control 62, interior coolant conduit 87, rear power high voltage DC-supply connection 36b, and rear communication and low voltage control bus connection 37b. Housing 30b protects the internal electronics of the module from the outside environment and provides front end actuator connections, backend base connections, and mounting connections when mounted on base 25 as shown and described.

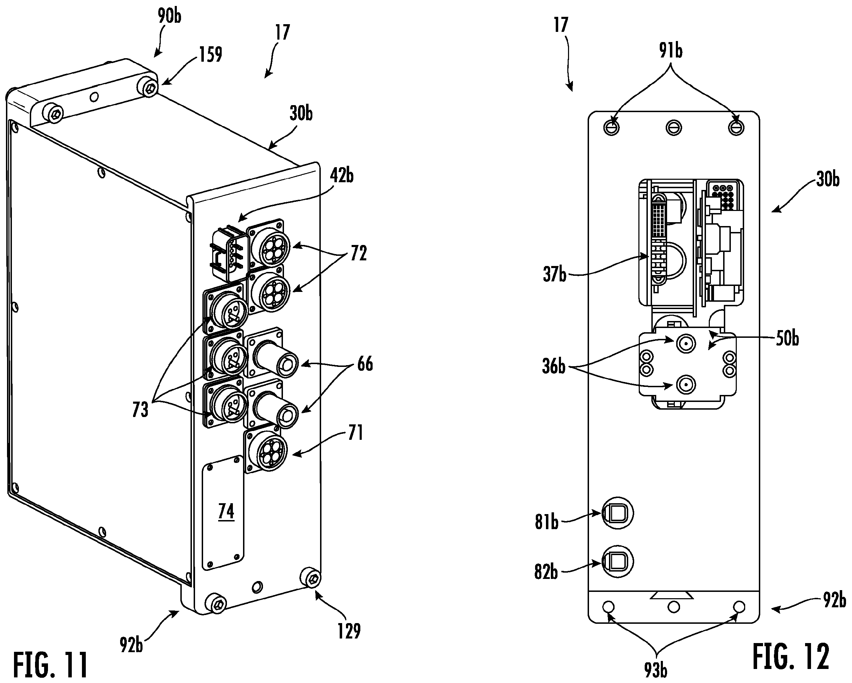

As shown in FIG. 11, the front panel of housing 30b includes high voltage DC power input connection 66, auxiliary battery connection 71, auxiliary 12V power connection 72, three auxiliary high voltage connections 73, fuse access panel 74, and auxiliary interface 42b. DC bus power input connection 66 is configured to connect to the main power source of mobile machine 29, which in this embodiment comprises electric vehicle main battery pack 70. Auxiliary battery connection 71 is configured to connect to an auxiliary battery, which in this embodiment comprises a lower voltage battery, such as for example a 12 volt battery. Connections 72 and 73 allow for the connection of module 17 to other external low and high voltage devices if desired and auxiliary interface 42b allows for the connection of the module to other external auxiliary sensors and functions if desired and may be, for example and without limitation, a USB port. The bottom front edge portion of housing 30b also includes mounting flange 92b having at least two horizontally spaced base plate mounting bolt holes, severally indicated at 93b, that are configured to receive corresponding module mounting bolts 129, such that module 17 may be removably mounted to base plate 26 as shown in FIGS 17E-17F.

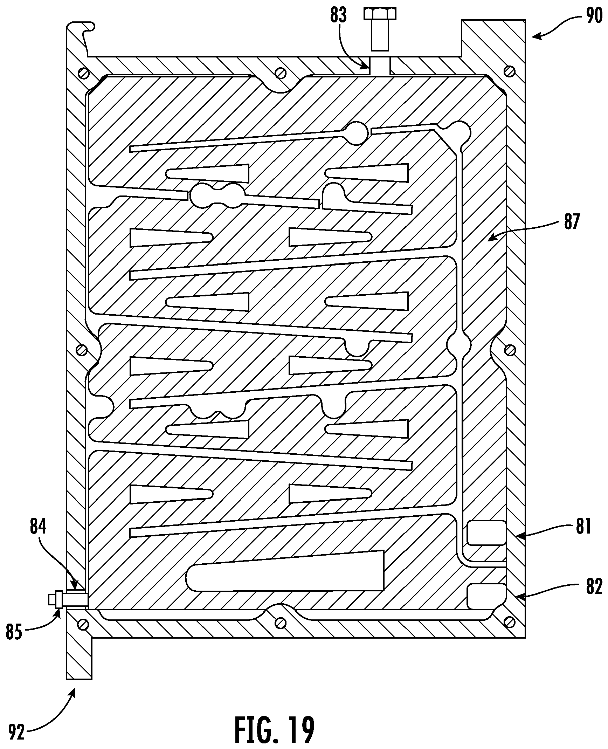

As shown in FIG. 12, the rear panel of housing 30b includes opening 50b through which power connection 36b is operatively connected to DC bus 170 of base 25 and also through which connection 37b is operatively connected to communications and control bus 160 of base 25. In this embodiment, rear power connection 36b is connected via copper busbars to power input connection 66 to bring high voltage power supply to DC bus 170 of base 25. The rear panel also includes coolant inlet port 81b and coolant outlet port 82b. As shown in FIG. 19, module coolant path 87 extends between inlet port 81 and outlet port 82. The top rear edge portion of housing 30b also includes mounting flange 90b having at least two horizontally-spaced base mounting bolt holes, severally indicated at 91b, that are configured to receive corresponding module mounting bolts 159, such that module 17 may be removably mounted to back plate 27 as shown in FIGS 17E-17F.

Power electronics 63 in housing 30b includes a master power board and provide high voltage operational power, via connection 36b and power bus 170 of base 25, to the actuator power electronics of modules 18-22. Control power electronics 62 provide lower voltage operational power, via control power bus 160a of bus 160 of base 25, to the actuator control electronics of modules 18-22 and the master control electronics of module 16. The auxiliary battery electronics are connected to an internal or an external auxiliary battery via auxiliary battery connection 71 to charge the auxiliary battery and power the system logic prior to the main power source being active. Low voltage control power bus 160a may be integrated into bus 160 and connections 162a, 162b, 162c, 162d, 162e, 162f and 162g, or alternatively may be a separate board in back plate 27 with separate connections to each of control electronics 32c and 32d and control power electronics 62.

In this embodiment actuator control or servodrive modules 18, 19 and 20 are dual axis controllers and each general comprises housing 30c containing dual axis power electronics 31c, control electronics 32c, interior coolant conduit 87, rear power high voltage DC-link connection 36c and rear communication control bus connection 37c. Housing 30c protects the internal electronics of the module from the outside environment and provides front end actuator connections, backend base connections, and mounting connections when mounted on base 25 as shown and described.

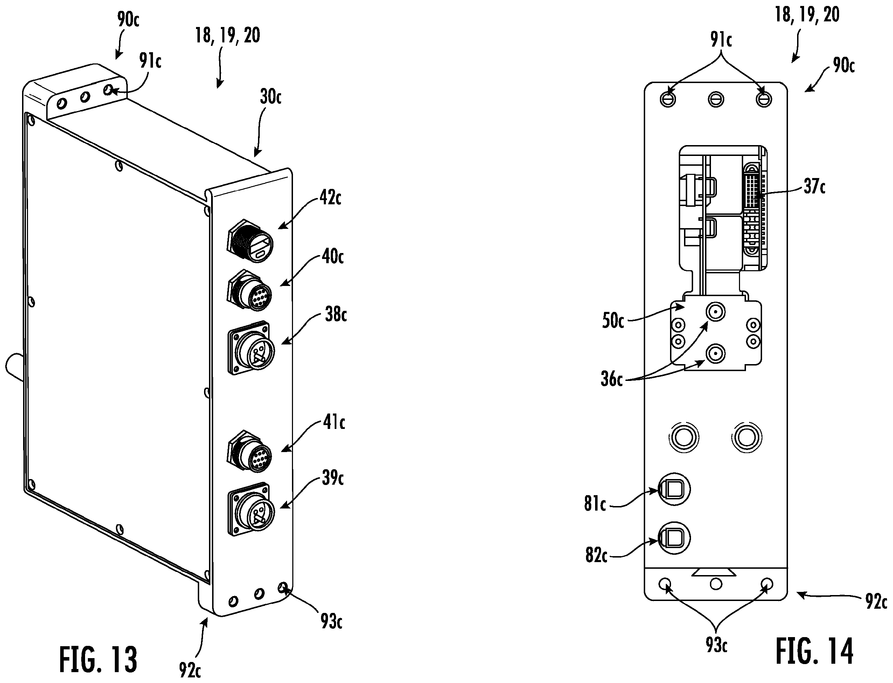

As shown in FIG. 13, the front panel of housing 30c includes first actuator power output connections 38c, second actuator power connection 39c, first actuator sensor feedback connection 40c, second actuator sensor feedback connection 41c, and in this embodiment auxiliary interface 42c. Actuator power connection 38c provides driving power to a first connected actuator, such as actuator 54 or 56, on mobile machine 29 and actuator sensor feedback connection 40c interfaces with the feedback sensors of the first connected actuator such as position sensors, temperature sensors, current sensors, and the like. Actuator power connection 39c provides driving power to a second connected actuator, such as actuator 55 or 57, on mobile machine 29 and actuator sensor feedback connection 41c interfaces with the feedback sensors of the second connected actuator, such as position sensors, temperature sensors, current sensors, and the like. Auxiliary interface 42c allows for the connection of the module to other external auxiliary sensors and functions if desired. The bottom front edge portion of housing 30c also includes mounting flange 92c having at least two horizontally spaced base plate mounting bolt holes, severally indicated at 93c, that are configured to receive corresponding module mounting bolts, severally indicated at 129, such that each of modules 18, 19 and 20 may be removably mounted to base plate 26 as shown in FIGS 17E-17F.

As shown in FIG. 14, the rear panel of housing 30c includes opening 50c through which power connection 36c is operatively connected to DC bus 170 of base 25 and also through which communication connection 37c is operatively connected to communications and control bus 160 of base 25. The rear panel also includes coolant inlet port 81c and coolant outlet port 82c. As shown in FIG. 19, module coolant path 87 extends between inlet port 81 and outlet port 82. The top rear edge portion of housing 30c also includes mounting flange 90c having at least two horizontally-spaced base mounting bolt holes, severally indicated at 91c, that are configured to receive corresponding module mounting bolts, severally indicated at 159, such that each of modules 18, 19 and 20 may be removably mounted to back plate 27 as shown in FIGS 17E-17F.

Power electronics 31c in housing 30c of each of modules 18, 19 and 20 may include a first axis power board and a second axis power board and provides operational power to the terminals of the connected electric motors, such as motors 54a, 55a and 56a, 57a, via actuator power connections 38c and 39c, respectively. The power electronics convert DC power from connection 36c to DC bus 170 of base 25 into a controlled Pulse Width Modulated (PWM) current which drives the connected motors. The operation of the power electronics is governed by PWM control signals from the power control interfaces of motor control electronics 32c. Motor control electronics 32c in housing 30c may include a control board and control, monitor, and supervise operation of the respective connected actuators, such as actuators 54-57, including the control of power to the respective actuator motors 54a-57a, respectively. Motor control electronics 32c may include a communication interface, a processor, a power control interface, and braking circuits for brake control and driving. A communication interface may provide communications with central control module 16 and if desired other actuator control modules via communication connection 37c and signal bus 160 of base 25. A processor may provide internal control and monitoring, receive commands from central controller module 16 and feedback from sensors recording operating parameters of the connected actuators, via actuator sensor connections 40c and 41c, respectively, and controls the respective actuators accordingly. In this embodiment, such sensors are coupled to the control electronics via wired connections 40c and 41c, but in other embodiments they may be coupled via a wireless connection.

One or more of the connected actuators may be rotary electromechanical actuators 54, 57 generally comprising variable speed bidirectional electric servomotors 54a, 57a, respectively, such as brushless D.C. variable-speed servo-motors with electronically controlled commutation systems that are supplied with a current and include resolver feedback to monitor rotor angle which is used for closed loop motion control in the actuator control electronics. Alternatively, one or more of the connected actuators may be linear electrohydraulic actuator 56 having electric motor 56a driving hydraulic pump 56b in a closed loop hydraulic circuit to extend and retract hydraulic cylinder driving mechanism 56c. In this embodiment, servo-motor 56a is used to drive reversible pump 56b to extend and retract piston 56d in cylinder 56e, with pump 56b pressurizing a working fluid, typically hydraulic oil, directly raising the pressure in a hydraulic gap on one side or the other of hydraulic piston 56d. In this embodiment motor 56a is a brushless D.C. variable-speed servo-motor that is supplied with a current. Other types of actuators or other motors may be used as alternatives. For example, a variable speed stepper motor, brush motor or induction motor may be used.

In this embodiment, actuator control or servodrive modules 21 and 22 are single axis controllers and each generally comprises housing 30d containing power electronics 31d, controller electronics 32d, interior coolant conduit, rear power high voltage DC-link connection 36d, and rear communication control bus connection 37d. Housing 30d protects the internal electronics of the module from the outside environment and provides front end actuator connections, backend base connections, and mounting connections when mounted on base 25 as shown and described.

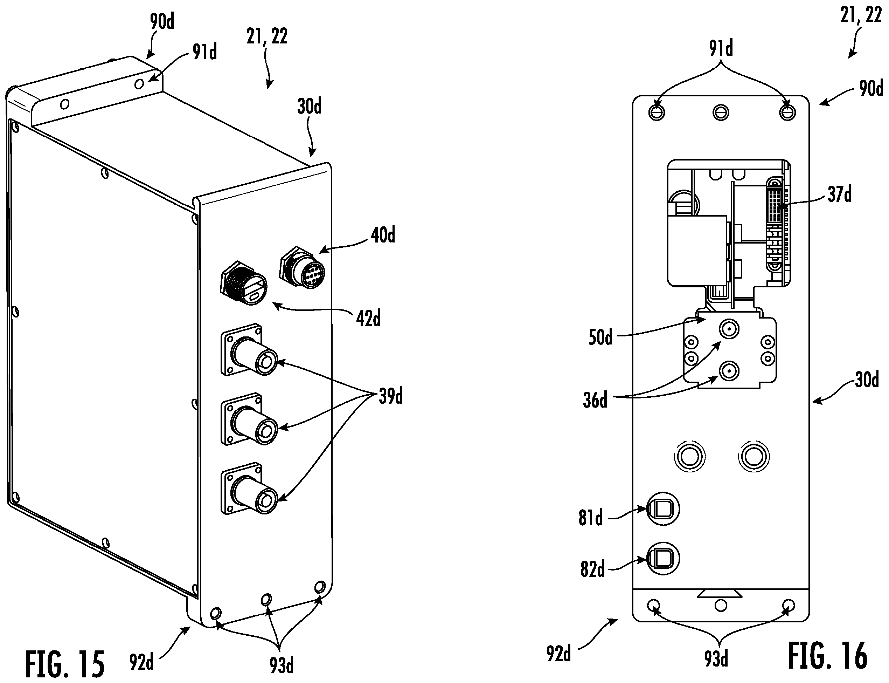

As shown in FIG. 15, the front panel of housing 30d includes actuator power output connections 39d, actuator sensor feedback connection 40d, and in this embodiment auxiliary interface 42d. Actuator power connection 39d provides driving power to a connected actuator, such as actuators 52 and 53, on mobile machine 29. Actuator sensor feedback connection 40d interfaces with the feedback sensors of the connected actuator, such as position sensors, temperature sensors, current sensors, and the like. Auxiliary interface 42d allows for the connection of the module to other external auxiliary sensors and functions if desired and may be, for example and without limitation, a USB port. The bottom front edge portion of housing 30d also includes mounting flange 92d having at least two horizontally spaced base plate mounting bolt holes, severally indicated at 93d, that are configured to receive corresponding module mounting bolts, severally indicated at 129, such that each of modules 21 and 22 may be removably mounted to base plate 26 as shown in FIGS 17E-17F.

As shown in FIG. 16, the rear panel of housing 30d includes opening 50d through which power connection 36d is operatively connected to DC bus 170 of base 25 and also through which communication connection 37d is operatively connected to communications and control bus 160 of base 25. The rear panel also includes coolant inlet port 81d and coolant outlet port 82d. As shown in FIG. 19, module coolant path 87 extends between inlet port 81 and outlet port 82. The top rear edge portion of housing 30d also includes mounting flange 90d having at least two horizontally-spaced base mounting bolt holes, severally indicated at 91d, that are configured to receive corresponding module mounting bolts, severally indicated at 159, such that each of modules 21 and 22 may be removably mounted to back plate 27 as shown in FIGS 17E-17F.

Power electronics 31d in housing 30d of each of modules 21 and 22 may include a power board and a capacitors board and provides operational power to the terminals of a connected electric motor, such as motors 52a and 53a, via actuator power connection 39d. The power electronics convert DC power from connection 36d to DC bus 170 of base 25 into a controlled Pulse Width Modulated (PWM) current which drives the connected motor. The operation of the power electronics is governed by PWM control signals from the power control interface of motor control electronics 32d. Motor control electronics 32d in housing 30d may include a control board and control, monitor, and supervise operation of the connected actuator, including the control of power to the actuator motor. Motor control electronics 32d may include a communication interface, a processor, a power control interface, and a braking circuit for brake control and driving. A communication interface may provide communications with central control module 16 and if desired other actuator control modules via communication connection 37d and signal bus 160 of base 25. A processor may provide internal control and monitoring, receive commands from central controller module 16 and feedback from sensors recording operating parameters of the connected actuator, via actuator sensor connection 40d, and controls the actuator accordingly. In this embodiment, such sensors are coupled to control electronics 32d via wired connection 40d, but in other embodiments they may be coupled via a wireless connection.

The connected actuator may be linear electromechanical actuator 52 having a three-phase permanent magnet DC electric motor 52a driving an output shaft. Feedback sensors may include a position sensor that provides position feedback, via connection 40d, to monitor shaft position which is used for closed loop motion control in motor control electronics 32d. A position sensor may be any electrical device for measuring the position, or a derivative of position, or distance from an object, examples of which include an encoder, a resolver, a linear variable differential transformer, a variable resistor, a variable capacitor, a laser rangefinder, an ultrasonic range detector, an infrared range detector, or other similar devices. Alternatively, the connected actuator may be rotary electrohydraulic actuator 53 generally comprising a variable speed bidirectional electric servomotor 53a and a bi-directional or reversible pump 53b driven by the motor. Control electronics 32d, based on position feedback via connection 40d, may generate and commutate the stator fields via power electronics 31d to vary the speed and direction of the motor 53a. Other types of actuators or other motors may be used as alternatives. For example, a variable speed stepper motor, brush motor or induction motor may be used.

As shown in FIG. 19, each of modules 17-22 may include a side portion having interior coolant conduit 87 between rear inlet port 81 and rear outlet port 82 that extends from the rear to the front of the subject module in close thermal proximity to the subject module's power electronics. An upper fill port 83 with a plug and lower drain port 84 with a bleeder valve may also be provided so the modules may be filled to avoid major air pockets and also fully drained. While a coolant path is shown, alternative passage geometries and porting may be used.

Modular control base mounting systems 15 and 215 have a number of advantages. Each of systems 15 and 215 provides a stack of individualized electronics modules that is liquid cooled, that is very compact, that is environmentally rugged, that is mechanically robust, that is expandable, and that is rated for environments such as compact earth moving equipment and mobile machines. Each of systems 15 and 215 is easily scalable and customizable, minimizes cables and hoses, provides increased operating voltage and is easy to maintain. The integrated cooling passages designed into base 25 or 225 and each module eliminates the need for external interconnections between them. Integrated electric bus connections in base 25 or 225 and each module, both power and control, eliminates the need for external interconnections between them. The individual stacked modular units may be customized in base 25 or 225 to provide individualized desired control electronics. The number and configuration of the modular units may be varied as desired for the application and conditions of the environment. The individual module units may also be line replaceable units (LRUs). The individual modules may have an Ingress Protection rating of at least IP44 and when mounted to base 25 may have an Ingress Protection rating of at least IP67K. Systems 15 and 215 are scalable in size by adding length to base 25 or 225 and module units to the stack as needed.

It should be appreciated that certain features of the system, which are, for clarity, described in the context of separate embodiments, may also be provided in combination in a single embodiment. Conversely, various features, which are, for brevity, described in the context of a single embodiment, may also be provided separately or in any suitable combination. While various embodiments have been described in detail above, it should be understood that they have been presented by way of example, and not limitation. While the presently preferred form of an improved modular actuator control module mounting base has been shown and described, and several modifications thereof discussed, persons skilled in this art will readily appreciate that various additional changes and modifications may be made without departing from the scope of the invention, as defined and differentiated by the claims.

## Claims

1. A modular actuator control system, comprising:
a module mounting base (25, 225);
a first drive module (18, 19, 20, 21, 22) operatively configured to control an electrically powered first actuator (52, 53, 54, 55, 56, 57) having at least one motion axis;
a second drive module (18, 19, 20, 21, 22) operatively configured to control an electrically power second actuator (52, 53, 54, 55, 56, 57) having at least one motion axis;
said module mounting base having a base housing (26, 27, 227) comprising:
a coolant inlet (181);
a first base attachment (128, 158, 228, 258);
a first base coolant port (188a, 188b, 189a, 189b, 190a, 190b, 191a, 191b, 192a, 192b);
a second base attachment (128, 228 158, 258);
a second base coolant port (188a, 188b, 189a, 189b, 190a, 190b, 191a, 191b, 192a, 192b);
a power bus (170); and
a signal bus (160);
said first drive module having a first drive housing (30c, 30d) comprising:
a first drive attachment (91c, 93c, 91d, 93d, 293) operatively configured to connect to said first base attachment;
a first power connection (36c, 36d) operatively configured to connect to said power bus;
a first signal connection (37c, 37d) operatively configured to connect to said signal bus;
a first actuator drive connection (38c, 39c, 39d) operatively configured to connect to said first actuator; and
a first coolant port (81c, 82c, 81d, 82d) operatively configured to connect to said first base coolant port;
said second drive module having a second drive housing (30c, 30d) comprising:
a second drive attachment (91c, 93c, 91d, 93d, 293) operatively configured to connect to said second base attachment;
a second power connection (36c, 36d) operatively configured to connect to said power bus;
a second signal connection (37c, 37d) operatively configured to connect to said signal bus;
a second actuator drive connection (38c, 39c, 39d) operatively configured to connect to said second actuator; and
a second coolant port (81c, 82c, 81d, 82d) operatively configured to connect to said second base coolant port; and
said first drive module and said second drive module operatively configured to be removably attached to said module mounting base and to be in power communications with said power bus, in signal communications with said signal bus, and in coolant fluid communication with said coolant inlet.

2. The modular actuator control system set forth in claim 1, wherein:
said first base coolant port comprises a first supply port (188a, 189a, 190a, 191a, 192a) and a first return port (188b, 189b, 190b, 191b, 192b);
said second base coolant port comprises a second supply port (188a, 189a, 190a, 191a, 192a) and a second return port (188b, 189b, 190b, 191b, 192b);
said first coolant port comprises a first inlet port and a first outlet port;
said second coolant port comprises a second inlet port (81c, 81d) and a second outlet port (82c, 82d);
said first drive housing comprises a first coolant fluid flow path (87) between said first inlet port and said first outlet port;
said second drive housing comprises a second coolant fluid flow path (87) between said second inlet port and said second outlet port;
said first supply port operatively configured to connect to said first inlet port and said first return port operatively configured to connect to said first outlet port; and
said second supply port operatively configured to connect to said second inlet port and said second return port operatively configured to connect to said second outlet port.

3. The modular actuator control system set forth in claim 2, wherein said base housing comprises a first base coolant passage (183b, 183c, 183d, 183e) between said first return port and said second supply port.

4. The modular actuator control system set forth in claim 1, comprising:
said base housing comprising:
a power base attachment (128b, 158b); and
a power base coolant port (187a, 187b);
a master power module (17) having a power housing (30b) comprising:
a power attachment (91b, 93b) operatively configured to connect to said power base attachment;
a master power connection (36b) operatively configured to connect to said power bus;
a system power connection (66) operatively configured to connect to a system power source (70); and
a power module coolant port (81b, 82b) operatively configured to connect to said power base coolant port; and
said master power module operatively configured to be removably attached to said module mounting base and to be in power communications with said power bus and in coolant fluid communication with said coolant inlet.

5. The modular actuator control system set forth in claim 4, wherein:
said first base coolant port comprises a first supply port (188a, 189a, 190a, 191a, 192a) and a first return port (188b, 189b, 190b, 191b, 192b);
said second base coolant port comprises a second supply port (188a, 189a, 190a, 191a, 192a) and a second return port (188b, 189b, 190b, 191b, 192b);
said power base coolant port comprises a power supply port (187a) and a power return port (187b);
said first coolant port comprises a first inlet port and a first outlet port;
said second coolant port comprises a second inlet port (81c, 81d) and a second outlet port (82c, 82d);
said power module coolant port comprises a power inlet port (81b) and a power outlet port (82b);
said first drive housing comprises a first coolant fluid flow path between said first inlet port and said first outlet port;
said second drive housing comprises a second coolant fluid flow path between said second inlet port and said second outlet port;
said power housing comprises a power coolant fluid flow path (87) between said power inlet port and said power outlet port;
said first supply port operatively configured to connect to said first inlet port and said first return port operatively configured to connect to said first outlet port;
said second supply port operatively configured to connect to said second inlet port and said second return port operatively configured to connect to said second outlet port; and
said power supply port operatively configured to connect to said power inlet port and said power return port operatively configured to connect to said power outlet port.

6. The modular actuator control system set forth in claim 5, comprising a pump (45) connected to said coolant inlet of said base housing and operatively configured to pump a fluid coolant through said first fluid coolant flow path of said first drive housing, said second fluid coolant flow path of said second housing, and said power coolant fluid flow path.

7. The modular actuator control system set forth in claim 1 or claim 4, comprising:
said base housing comprising a control base attachment (128a, 128b);
a master controller module (16) having a controller housing (30a) comprising:
a controller attachment (91a, 93a) operatively configured to connect to said control base attachment;
a controller signal connection (37a) operatively configured to connect to said signal bus; and
a system controller connection (64) operatively configured to communicate with a system controller (60); and
said master controller module operatively configured to be removably attached to said module mounting base and to be in signal communication with said signal bus.

8. The modular actuator control system set forth in claim 9, wherein said master power module is supported by said module mounting base between said master controller module and said first drive module.

9. The modular actuator control system set forth in claim 5, wherein said system power source comprises an electric-vehicle battery (70), and optionally wherein said power housing comprises a power signal connection (37b) operatively configured to connect to said signal bus.

10. The modular actuator control system set forth in claim 1, wherein:
said first base attachment comprises a first base bolt hole (128, 158, 228, 258);
said first drive attachment comprises a first module bolt hole (91c, 93c, 91d, 93d, 293);
and said first drive attachment is operatively configured to connect to said first base attachment via a first bolt (129, 159, 229, 259) extending between and through said first base bolt hole and said first module bolt hole.

11. The modular actuator control system set forth in claim 1, wherein said base housing comprises a base plate (26) and a back plate (27) and said power bus and said signal bus are contained in said back plate.

12. The modular actuator control system set forth in claim 11, wherein said first base attachment comprises a base plate attachment (128) and a back plate attachment (158), and optionally wherein said base plate comprises a first base keyway (118, 119, 120, 121, 122) configured to mate with a corresponding key of said first drive module and a second base keyway (118, 119, 120, 121, 122) configured to mate with a corresponding key of said second drive module.

13. The modular actuator control system set forth in claim 11, wherein said coolant inlet comprises an inlet port in said back plate and comprising an outlet port (182) in said back plate.

14. The modular actuator control system set forth in claim 1, wherein said base housing comprises a back plate (227) and said power bus and said signal bus are contained in said back plate.

15. The modular actuator control system set forth in claim 14, wherein said first base attachment comprises a first back plate attachment (228) and a second back plate attachment (258), and optionally wherein said back plate comprises a first keyway (216) configured to mate with a corresponding key of said first drive module and a second keyway configured to mate with a corresponding key of said second drive module.

## Patentansprüche

1. Modulares Aktuator-Steuerungssystem, umfassend:
eine Modulmontagebasis (25, 225);
ein erstes Antriebsmodul (18, 19, 20, 21, 22), das betriebsmäßig konfiguriert ist, um einen elektrisch betriebenen ersten Aktuator (52, 53, 54, 55, 56, 57) mit mindestens einer Bewegungsachse zu steuern;
ein zweites Antriebsmodul (18, 19, 20, 21, 22), das betriebsmäßig konfiguriert ist, um einen elektrisch betriebenen zweiten Aktuator (52, 53, 54, 55, 56, 57) mit mindestens einer Bewegungsachse zu steuern;
wobei die Modulmontagebasis ein Basisgehäuse (26, 27, 227) aufweist, umfassend:
einen Kühlmitteleinlass (181);
eine erste Basisbefestigung (128, 158, 228, 258);
einen ersten Basiskühlmittelanschluss (188a, 188b, 189a, 189b, 190a, 190b, 191a, 191b, 192a, 192b);
eine zweite Basisbefestigung (128, 228 158, 258);
einen zweiten Basiskühlmittelanschluss (188a, 188b, 189a, 189b, 190a, 190b, 191a, 191b, 192a, 192b);
einen Strombus (170); und
einen Signalbus (160);
wobei das erste Antriebsmodul ein erstes Antriebsgehäuse (30c, 30d) aufweist, umfassend:
eine erste Antriebsbefestigung (91c, 93c, 91d, 93d, 293), die betriebsmäßig konfiguriert ist, um mit der ersten Basisbefestigung verbunden zu werden;
eine erste Stromverbindung (36c, 36d), die betriebsmäßig konfiguriert ist, um mit dem Strombus verbunden zu werden;
eine erste Signalverbindung (37c, 37d), die betriebsmäßig konfiguriert ist, um mit dem Signalbus verbunden zu werden;
eine erste Aktuatorantriebsverbindung (38c, 39c, 39d), die betriebsmäßig konfiguriert ist, um mit dem ersten Aktuator verbunden zu werden; und
einen ersten Kühlmittelanschluss (81c, 82c, 81d, 82d), der betriebsmäßig konfiguriert ist, um mit dem ersten Basiskühlmittelanschluss verbunden zu werden;
wobei das zweite Antriebsmodul ein zweites Antriebsgehäuse (30c, 30d) aufweist, umfassend:
eine zweite Antriebsbefestigung (91c, 93c, 91d, 93d, 293), die betriebsmäßig konfiguriert ist, um mit der zweiten Basisbefestigung verbunden zu werden;
eine zweite Stromverbindung (36c, 36d), die betriebsmäßig konfiguriert ist, um mit dem Strombus verbunden zu werden;
eine zweite Signalverbindung (37c, 37d), die betriebsmäßig konfiguriert ist, um mit dem Signalbus verbunden zu werden;
eine zweite Aktuatorantriebsverbindung (38c, 39c, 39d), die betriebsmäßig konfiguriert ist, um mit dem zweiten Aktuator verbunden zu werden; und
einen zweiten Kühlmittelanschluss (81c, 82c, 81d, 82d), der betriebsmäßig konfiguriert ist, um mit dem zweiten Basiskühlmittelanschluss verbunden zu werden; und
wobei das erste Antriebsmodul und das zweite Antriebsmodul betriebsmäßig konfiguriert sind, um lösbar an der Modulmontagebasis angebracht zu sein und in Stromverbindung mit dem Strombus, in Signalverbindung mit dem Signalbus und in Kühlmittel-Fluidverbindung mit dem Kühlmitteleinlass zu stehen.

2. Modulares Aktuator-Steuerungssystem nach Anspruch 1, wobei:
der erste Basiskühlmittelanschluss einen ersten Zuführanschluss (188a, 189a, 190a, 191a, 192a) und einen ersten Rücklaufanschluss (188b, 189b, 190b, 191b, 192b) umfasst;
der zweite Basiskühlmittelanschluss einen zweiten Zuführanschluss (188a, 189a, 190a, 191a, 192a) und einen zweiten Rücklaufanschluss (188b, 189b, 190b, 191b, 192b) umfasst;
der erste Kühlmittelanschluss einen ersten Einlassanschluss und einen ersten Auslassanschluss umfasst;
der zweite Kühlmittelanschluss einen zweiten Einlassanschluss (81c, 81d) und einen zweiten Auslassanschluss (82c, 82d) umfasst;
das erste Antriebsgehäuse einen ersten Kühlmittelfluidströmungsweg (87) zwischen dem ersten Einlassanschluss und dem ersten Auslassanschluss umfasst;
das zweite Antriebsgehäuse einen zweiten Kühlmittelfluidströmungsweg (87) zwischen dem zweiten Einlassanschluss und dem zweiten Auslassanschluss umfasst;
der erste Zuführanschluss betriebsmäßig konfiguriert ist, um mit dem ersten Einlassanschluss verbunden zu werden, und der erste Rücklaufanschluss betriebsmäßig konfiguriert ist, um mit dem ersten Auslassanschluss verbunden zu werden; und
der zweite Zuführanschluss betriebsmäßig konfiguriert ist, um mit dem zweiten Einlassanschluss verbunden zu werden, und der zweite Rücklaufanschluss betriebsmäßig konfiguriert ist, um mit dem zweiten Auslassanschluss verbunden zu werden.

3. Modulares Aktuator-Steuerungssystem nach Anspruch 2, wobei das Basisgehäuse einen ersten Basiskühlmitteldurchgang (183b, 183c, 183d, 183e) zwischen dem ersten Rücklaufanschluss und dem zweiten Zuführanschluss umfasst.

4. Modulares Aktuator-Steuerungssystem nach Anspruch 1, umfassend:
das Basisgehäuse umfassend:
eine Strombasisbefestigung (128b, 158b); und
einen Strombasiskühlmittelanschluss (187a, 187b);
ein Hauptstrommodul (17) mit einem Stromgehäuse (30b) umfassend:
eine Strombefestigung (91b, 93b), die betriebsmäßig konfiguriert ist, um mit der Strombasisbefestigung verbunden zu werden;
eine Hauptstromverbindung (36b), die betriebsmäßig konfiguriert ist, um mit dem Strombus verbunden zu werden;
eine Systemstromverbindung (66), die betriebsmäßig konfiguriert ist, um mit einer Systemstromquelle (70) verbunden zu werden; und
einen Strommodulkühlmittelanschluss (81b, 82b), der betriebsmäßig konfiguriert ist, um mit dem Strombasiskühlmittelanschluss verbunden zu werden; und
wobei das Hauptstrommodul betriebsmäßig konfiguriert ist, um lösbar an der Modulmontagebasis befestigt zu sein und in Stromverbindung mit dem Strombus und in Kühlmittel-Fluidverbindung mit dem Kühlmitteleinlass zu stehen.

5. Modulares Aktuator-Steuerungssystem nach Anspruch 4, wobei:
der erste Basiskühlmittelanschluss einen ersten Zuführanschluss (188a, 189a, 190a, 191a, 192a) und einen ersten Rücklaufanschluss (188b, 189b, 190b, 191b, 192b) umfasst;
der zweite Basiskühlmittelanschluss einen zweiten Zuführanschluss (188a, 189a, 190a, 191a, 192a) und einen zweiten Rücklaufanschluss (188b, 189b, 190b, 191b, 192b) umfasst;
wobei der Strombasiskühlmittelanschluss einen Stromzuführanschluss (187a) und einen Stromrücklaufanschluss (187b) umfasst;
der erste Kühlmittelanschluss einen ersten Einlassanschluss und einen ersten Auslassanschluss umfasst;
der zweite Kühlmittelanschluss einen zweiten Einlassanschluss (81c, 81d) und einen zweiten Auslassanschluss (82c, 82d) umfasst;
der Strommodulkühlmittelanschluss einen Stromeinlassanschluss (81b) und einen Stromauslassanschluss (82b) umfasst;
das erste Antriebsgehäuse einen ersten Kühlmittelfluidströmungsweg zwischen dem ersten Einlassanschluss und dem ersten Auslassanschluss umfasst;
das zweite Antriebsgehäuse einen zweiten Kühlmittelfluidströmungsweg zwischen dem zweiten Einlassanschluss und dem zweiten Auslassanschluss umfasst;
das Stromgehäuse einen Stromkühlmittelfluidströmungsweg (87) zwischen dem Stromeinlassanschluss und dem Stromauslassanschluss umfasst;
der erste Zuführanschluss betriebsmäßig konfiguriert ist, um mit dem ersten Einlassanschluss verbunden zu werden, und der erste Rücklaufanschluss betriebsmäßig konfiguriert ist, um mit dem ersten Auslassanschluss verbunden zu werden;
der zweite Zuführanschluss betriebsmäßig konfiguriert ist, um mit dem zweiten Einlassanschluss verbunden zu werden, und der zweite Rücklaufanschluss betriebsmäßig konfiguriert ist, um mit dem zweiten Auslassanschluss verbunden zu werden; und
der Stromzuführanschluss betriebsmäßig konfiguriert ist, um mit dem Stromeinlassanschluss verbunden zu werden, und der Stromücklaufanschluss betriebsmäßig konfiguriert ist, um mit dem Stromauslassanschluss verbunden zu werden.

6. Modulares Aktuator-Steuerungssystem nach Anspruch 5, umfassend eine Pumpe (45), die mit dem Kühlmitteleinlass des Basisgehäuses verbunden und betriebsmäßig konfiguriert ist, um ein fluides Kühlmittel durch den ersten Fluidkühlmittelströmungsweg des ersten Antriebsgehäuses, den zweiten Fluidkühlmittelströmungsweg des zweiten Gehäuses und den Stromkühlmittelfluidströmungsweg zu pumpen.

7. Modulares Aktuator-Steuerungssystem nach Anspruch 1 oder Anspruch 4, umfassend:
das Basisgehäuse umfassend eine Steuerungsbasisbefestigung (128a, 128b);
ein Hauptsteuerungsmodul (16) mit einem Steuerungsgehäuse (30a) umfassend:
eine Steuerungsbefestigung (91b, 93b), die betriebsmäßig konfiguriert ist, um mit der Steuerungsbasisbefestigung verbunden zu werden;
eine Steuerungssignalverbindung (37a), die betriebsmäßig konfiguriert ist, um mit dem Signalbus verbunden zu werden; und
eine Systemsteuerungsverbindung (64), die betriebsmäßig konfiguriert ist, um mit einer Systemsteuerung (60) zu kommunizieren; und
wobei das Hauptsteuerungsmodul betriebsmäßig konfiguriert ist, um lösbar an der Modulmontagebasis befestigt zu sein und in Signalverbindung mit dem Signalbus zu stehen.

8. Modulares Aktuator-Steuerungssystem nach Anspruch 9, wobei das Hauptstrommodul von der Modulmontagebasis zwischen dem Hauptsteuerungsmodul und dem ersten Antriebsmodul getragen wird.

9. Modulares Aktuator-Steuerungssystem nach Anspruch 5, wobei die Systemstromquelle eine Elektrofahrzeugbatterie (70) umfasst, und gegebenenfalls wobei das Stromgehäuse eine Stromsignalverbindung (37b) umfasst, die betriebsmäßig konfiguriert ist, um mit dem Signalbus verbunden zu werden.

10. Modulares Aktuator-Steuerungssystem nach Anspruch 1, wobei:
die erste Basisbefestigung ein erstes Basisbolzenloch (128, 158, 228, 258) umfasst;
die erste Antriebsbefestigung ein erstes Modulbolzenloch (91c, 93c, 91d, 93d, 293) umfasst;
und die erste Antriebsbefestigung betriebsmäßig konfiguriert ist, um mit der ersten Basisbefestigung über einen ersten Bolzen (129, 159, 229, 259) verbunden zu werden, der sich zwischen dem ersten Basisbolzenloch und dem ersten Modulbolzenloch und durch diese hindurch erstreckt.

11. Modulares Aktuator-Steuerungssystem nach Anspruch 1, wobei das Basisgehäuse eine Bodenplatte (26) und eine Rückplatte (27) umfasst und der Strombus und der Signalbus in der Rückplatte enthalten sind.

12. Modulares Aktuator-Steuerungssystem nach Anspruch 11, wobei die erste Basisbefestigung eine Bodenplattenbefestigung (128) und eine Rückplattenbefestigung (158) umfasst, und gegebenenfalls wobei die Bodenplatte eine erste Basiskeilnut (118, 119, 120, 121, 122), die konfiguriert ist, um mit einem entsprechenden Keil des ersten Antriebsmoduls zusammenzupassen, und eine zweite Basiskeilnut (118, 119, 120, 121, 122), die konfiguriert ist, um mit einem entsprechenden Keil des zweiten Antriebsmoduls zusammenzupassen, umfasst.

13. Modulares Aktuator-Steuerungssystem nach Anspruch 11, wobei der Kühlmitteleinlass einen Einlassanschluss in der Rückplatte umfasst und einen Auslassanschluss (182) in der Rückplatte umfasst.

14. Modulares Aktuator-Steuerungssystem nach Anspruch 1, wobei das Basisgehäuse eine Rückplatte (227) umfasst und der Strombus und der Signalbus in der Rückplatte enthalten sind.

15. Modulares Aktuator-Steuerungssystem nach Anspruch 14, wobei die erste Basisbefestigung eine erste Rückplattenbefestigung (228) und eine zweite Rückplattenbefestigung (258) umfasst, und gegebenenfalls wobei die Rückplatte eine erste Keilnut (216), die konfiguriert ist, um mit einem entsprechenden Keil des ersten Antriebsmoduls zusammenzupassen, und eine zweite Keilnut, die konfiguriert ist, um mit einem entsprechenden Keil des zweiten Antriebsmoduls zusammenzupassen, umfasst.

## Revendications

1. Système de commande d'actionneur modulaire, comprenant :
une base de montage de module (25, 225) ;
un premier module d'entraînement (18, 19, 20, 21, 22) configuré de manière fonctionnelle pour commander un premier actionneur alimenté électriquement (52, 53, 54, 55, 56, 57) ayant au moins un axe de mouvement ;
un second module d'entraînement (18, 19, 20, 21, 22) configuré de manière fonctionnelle pour commander un second actionneur alimenté électriquement (52, 53, 54, 55, 56, 57) ayant au moins un axe de mouvement ;
ladite base de montage de module ayant un boîtier de base (26, 27, 227) comprenant :
une entrée de liquide de refroidissement (181) ;
une première fixation de base (128, 158, 228, 258) ;
un premier orifice de liquide de refroidissement de base (188a, 188b, 189a, 189b, 190a, 190b, 191a, 191b, 192a, 192b) ;
une seconde fixation de base (128, 228, 158, 258) ;
un second orifice de liquide de refroidissement de base (188a, 188b, 189a, 189b, 190a, 190b, 191a, 191b, 192a, 192b) ;
un bus de puissance (170) ; et
un bus de signal (160) ;
ledit premier module d'entraînement ayant un premier boîtier d'entraînement (30c, 30d) comprenant :
une première fixation d'entraînement (91c, 93c, 91d, 93d, 293) conçue de manière fonctionnelle pour se lier à ladite première fixation de base ;
une première connexion de puissance (36c, 36d) configurée de manière fonctionnelle pour se connecter audit bus de puissance ;
une première connexion de signal (37c, 37d) configurée de manière fonctionnelle pour se connecter audit bus de signal ;
une première connexion d'entraînement d'actionneur (38c, 39c, 39d) configurée de manière fonctionnelle pour se connecter audit premier actionneur ; et
un premier orifice de liquide de refroidissement (81c, 82c, 81d, 82d) conçu de manière fonctionnelle pour se raccorder audit premier orifice de liquide de refroidissement de base ;
ledit second module d'entraînement ayant un second boîtier d'entraînement (30c, 30d) comprenant :
une seconde fixation d'entraînement (91c, 93c, 91d, 93d, 293) conçue de manière fonctionnelle pour se lier à ladite seconde fixation de base ;
une seconde connexion de puissance (36c, 36d) configurée de manière fonctionnelle pour se connecter audit bus de puissance ;
une seconde connexion de signal (37c, 37d) configurée de manière fonctionnelle pour se connecter audit bus de signal ;
une seconde connexion d'entraînement d'actionneur (38c, 39c, 39d) configurée de manière fonctionnelle pour se connecter audit second actionneur ; et
un second orifice de liquide de refroidissement (81c, 82c, 81d, 82d) conçu de manière fonctionnelle pour se raccorder audit second orifice de liquide de refroidissement de base ; et
ledit premier module d'entraînement et ledit second module d'entraînement étant configurés de manière fonctionnelle pour être fixés de manière amovible à ladite base de montage de module et pour être en communication de puissance avec ledit bus de puissance, en communication de signal avec ledit bus de signal, et en communication de liquide de refroidissement avec ladite entrée de liquide de refroidissement.

2. Système de commande d'actionneur modulaire selon la revendication 1, dans lequel :
ledit premier orifice de liquide de refroidissement de base comprend un premier orifice d'alimentation (188a, 189a, 190a, 191a, 192a) et un premier orifice de retour (188b, 189b, 190b, 191b, 192b) ;
ledit second orifice de liquide de refroidissement de base comprend un second orifice d'alimentation (188a, 189a, 190a, 191a, 192a) et un second orifice de retour (188b, 189b, 190b, 191b, 192b) ;
ledit premier orifice de liquide de refroidissement comprend un premier orifice d'entrée et un premier orifice de sortie ;
ledit second orifice de liquide de refroidissement comprend un second orifice d'entrée (81c, 81d) et un second orifice de sortie (82c, 82d) ;
ledit premier boîtier d'entraînement comprend un premier trajet d'écoulement de liquide de refroidissement (87) entre ledit premier orifice d'entrée et ledit premier orifice de sortie ;
ledit second boîtier d'entraînement comprend un second trajet d'écoulement de liquide de refroidissement (87) entre ledit second orifice d'entrée et ledit second orifice de sortie ;
ledit premier orifice d'alimentation étant conçu de manière fonctionnelle pour se raccorder audit premier orifice d'entrée et ledit premier orifice de retour étant conçu de manière fonctionnelle pour se raccorder audit premier orifice de sortie ; et
ledit second orifice d'alimentation étant conçu de manière fonctionnelle pour se raccorder audit second orifice d'entrée et ledit second orifice de retour étant conçu de manière fonctionnelle pour se raccorder audit second orifice de sortie.

3. Système de commande d'actionneur modulaire selon la revendication 2, dans lequel ledit boîtier de base comprend un premier passage de liquide de refroidissement de base (183b, 183c, 183d, 183e) entre ledit premier orifice de retour et ledit second orifice d'alimentation.

4. Système de commande d'actionneur modulaire selon la revendication 1, comprenant :
ledit boîtier de base comprenant :
une fixation de base de puissance (128b, 158b) ; et
un orifice de liquide de refroidissement de base de puissance (187a, 187b) ;
un module de puissance maître (17) ayant un boîtier de puissance (30b) comprenant :
une fixation de puissance (91b, 93b) conçue de manière fonctionnelle pour se lier à ladite fixation de base de puissance ;
une connexion de puissance maître (36b) configurée de manière fonctionnelle pour se connecter audit bus de puissance ;
une connexion de puissance de système (66) configurée de manière fonctionnelle pour se connecter à une source de puissance de système (70) ; et
un orifice de liquide de refroidissement de module de puissance (81b, 82b) conçu de manière fonctionnelle pour se raccorder audit orifice de liquide de refroidissement de base de puissance ; et
ledit module de puissance maître étant configuré de manière fonctionnelle pour être fixé de manière amovible à ladite base de montage de module et pour être en communication de puissance avec ledit bus de puissance et en communication de liquide de refroidissement avec ladite entrée de liquide de refroidissement.

5. Système de commande d'actionneur modulaire selon la revendication 4, dans lequel :
ledit premier orifice de liquide de refroidissement de base comprend un premier orifice d'alimentation (188a, 189a, 190a, 191a, 192a) et un premier orifice de retour (188b, 189b, 190b, 191b, 192b) ;
ledit second orifice de liquide de refroidissement de base comprend un second orifice d'alimentation (188a, 189a, 190a, 191a, 192a) et un second orifice de retour (188b, 189b, 190b, 191b, 192b) ;
ledit orifice de liquide de refroidissement de base de puissance comprend un orifice d'alimentation de puissance (187a) et un orifice de retour de puissance (187b) ;
ledit premier orifice de liquide de refroidissement comprend un premier orifice d'entrée et un premier orifice de sortie ;
ledit second orifice de liquide de refroidissement comprend un second orifice d'entrée (81c, 81d) et un second orifice de sortie (82c, 82d) ;
ledit orifice de liquide de refroidissement de module de puissance comprend un orifice d'entrée de puissance (81b) et un orifice de sortie de puissance (82b) ;
ledit premier boîtier d'entraînement comprend un premier trajet d'écoulement de liquide de refroidissement entre ledit premier orifice d'entrée et ledit premier orifice de sortie ;
ledit second boîtier d'entraînement comprend un second trajet d'écoulement de liquide de refroidissement entre ledit second orifice d'entrée et ledit second orifice de sortie ;
ledit boîtier de puissance comprend un trajet d'écoulement de liquide de refroidissement de puissance (87) entre ledit orifice d'entrée de puissance et ledit orifice de sortie de puissance ;
ledit premier orifice d'alimentation étant conçu de manière fonctionnelle pour se raccorder audit premier orifice d'entrée et ledit premier orifice de retour étant conçu de manière fonctionnelle pour se raccorder audit premier orifice de sortie ;
ledit second orifice d'alimentation étant conçu de manière fonctionnelle pour se raccorder audit second orifice d'entrée et ledit second orifice de retour étant conçu de manière fonctionnelle pour se raccorder audit second orifice de sortie ; et
ledit orifice d'alimentation de puissance étant configuré de manière fonctionnelle pour se connecter audit orifice d'entrée de puissance et ledit orifice de retour de puissance étant configuré de manière fonctionnelle pour se connecter audit orifice de sortie de puissance.

6. Système de commande d'actionneur modulaire selon la revendication 5, comprenant une pompe (45) raccordée à ladite entrée de liquide de refroidissement dudit boîtier de base et configurée de manière fonctionnelle pour pomper un liquide de refroidissement à travers ledit premier trajet d'écoulement de liquide de refroidissement dudit premier boîtier d'entraînement, ledit second trajet d'écoulement de liquide de refroidissement dudit second boîtier, et ledit trajet d'écoulement de liquide de refroidissement de puissance.

7. Système de commande d'actionneur modulaire selon la revendication 1 ou la revendication 4, comprenant :
ledit boîtier de base comprenant une fixation de base de commande (128a, 128b) ;
un module de dispositif de commande maître (16) ayant un boîtier de dispositif de commande (30a) comprenant :
une fixation de dispositif de commande (91a, 93a) conçue de manière fonctionnelle pour se lier à ladite fixation de base de commande ;
une connexion de signal de dispositif de commande (37a) configurée de manière fonctionnelle pour se connecter audit bus de signal ; et
une connexion de dispositif de commande de système (64) configurée de manière fonctionnelle pour communiquer avec un dispositif de commande de système (60) ; et
ledit module de dispositif de commande maître étant configuré de manière fonctionnelle pour être fixé de manière amovible à ladite base de montage de module et pour être en communication de signal avec ledit bus de signal.

8. Système de commande d'actionneur modulaire selon la revendication 9, dans lequel ledit module de puissance maître est supporté par ladite base de montage de module entre ledit module de dispositif de commande maître et ledit premier module d'entraînement.

9. Système de commande d'actionneur modulaire selon la revendication 5, dans lequel ladite source de puissance de système comprend une batterie de véhicule électrique (70), et facultativement dans lequel ledit boîtier de puissance comprend une connexion de signal de puissance (37b) configurée de manière fonctionnelle pour se connecter audit bus de signal.

10. Système de commande d'actionneur modulaire selon la revendication 1, dans lequel :
ladite première fixation de base comprend un premier trou de boulon de base (128, 158, 228, 258) ;
ladite première fixation d'entraînement comprend un premier trou de boulon de module (91c, 93c, 91d, 93d, 293) ;
et ladite première fixation d'entraînement est conçue de manière fonctionnelle pour se lier à ladite première fixation de base par l'intermédiaire d'un premier boulon (129, 159, 229, 259) s'étendant entre et à travers ledit premier trou de boulon de base et ledit premier trou de boulon de module.

11. Système de commande d'actionneur modulaire selon la revendication 1, dans lequel ledit boîtier de base comprend une plaque de base (26) et une plaque arrière (27) et ledit bus de puissance et ledit bus de signal sont contenus dans ladite plaque arrière.

12. Système de commande d'actionneur modulaire selon la revendication 11, dans lequel ladite première fixation de base comprend une fixation de plaque de base (128) et une fixation de plaque arrière (158), et facultativement dans lequel ladite plaque de base comprend une première rainure de clavette de base (118, 119, 120, 121, 122) conçue pour s'accoupler avec une clavette correspondante dudit premier module d'entraînement et une seconde rainure de clavette de base (118, 119, 120, 121, 122) conçue pour s'accoupler avec une clavette correspondante dudit second module d'entraînement.

13. Système de commande d'actionneur modulaire selon la revendication 11, dans lequel ladite entrée de liquide de refroidissement comprend un orifice d'entrée dans ladite plaque arrière et comprenant un orifice de sortie (182) dans ladite plaque arrière.

14. Système de commande d'actionneur modulaire selon la revendication 1, dans lequel ledit boîtier de base comprend une plaque arrière (227) et ledit bus de puissance et ledit bus de signal sont contenus dans ladite plaque arrière.

15. Système de commande d'actionneur modulaire selon la revendication 14, dans lequel ladite première fixation de base comprend une première fixation de plaque arrière (228) et une seconde fixation de plaque arrière (258), et facultativement dans lequel ladite plaque arrière comprend une première rainure de clavette (216) conçue pour s'accoupler avec une clavette correspondante dudit premier module d'entraînement et une seconde rainure de clavette conçue pour s'accoupler avec une clavette correspondante dudit second module d'entraînement.
